# FASCICULE DE BREVET EUROPEEN

(11) **EP 1 578 858 B1**
(45) Date de publication et mention de la délivrance du brevet: **22.08.2012**
(21) Numéro de dépôt: 03814504.1
(22) Date de dépôt: 29.12.2003
(51) Int. Cl.: C08K 7/24

(54) **NANOTUBES DE CARBONE**
KOHLENSTOFFNANORÖHREN
CARBON NANOTUBES

(30) Priorité: 30.12.2002 FR 0216881
(43) Date de publication de la demande: 28.09.2005
(73) Titulaire: Nanoledge, 34830 Clapiers (FR)
(72) Inventeur: SCHIERHOLZ, Kai, 34000 Montpellier (FR)
(74) Mandataire: Mendelsohn, Isabelle M. N.
(86) Numéro de dépôt international: PCT/FR2003/003928
(87) Numéro de publication internationale: WO 2004/060988

(56) Documents cités:
- WO-A-02/076888
- WO-A-02/088025
- DATABASE COMPENDEX [Online] ENGINEERING INFORMATION, INC., NEW YORK, NY, US; KYMAKIS E ET AL: "Photovoltaic cells based on dye-sensitisation of single-wall carbon nanotubes in a polymer matrix" XP002262832 Database accession no. E2003457713226 & SOL ENERG MATER SOL CELLS;SOLAR ENERGY MATERIALS AND SOLAR CELLS DECEMBER 2003, vol. 80, no. 4, décembre 2003 (2003-12), pages 465-472, XP004470055
- ZHANG, JIAN; LEE, J.K.; WU, YUE; MURRAY, ROYCE W.: "Photoluminescence and Electronic Interaction of Anthracene Derivatives Adsorbed on Sidewalls of Sigle-Walled Carbon nanotubes" NANO LETTERS, vol. 3, no. 3, 2 décembre 2003 (2003-12-02), pages 403-407, XP002262831 & DATABASE CHEMICAL ABSTRACT [Online] extrait de CHEMICAL ABSTRACT Database accession no. 138:160435
- AGO H ET AL: "COMPOSITES OF CARBON NANOTUBES AND CONJUGATED POLYMERS FOR PHOTOVOLTAIC DEVICES" ADVANCED MATERIALS, VCH VERLAGSGESELLSCHAFT, WEINHEIM, DE, vol. 11, no. 15, 20 octobre 1999 (1999-10-20), pages 1281-1285, XP000869420 ISSN: 0935-9648
- BIERCUK M J ET AL: "CARBON NANOTUBE COMPOSITES FOR THERMAL MANAGEMENT" APPLIED PHYSICS LETTERS, AMERICAN INSTITUTE OF PHYSICS. NEW YORK, US, vol. 80, no. 15, 15 avril 2002 (2002-04-15), pages 2767-2769, XP001123908 ISSN: 0003-6951 cité dans la demande
- QIAN D ET AL: "LOAD TRANSFER AND DEPORMATION MECHANISMS IN CARBON NANOTUBE-POLYSTYRENE COMPOSITIES" APPLIED PHYSICS LETTERS, AMERICAN INSTITUTE OF PHYSICS. NEW YORK, US, vol. 76, no. 20, 15 mai 2000 (2000-05-15), pages 2868-2870, XP000950479 ISSN: 0003-6951 cité dans la demande

## Description

L'invention concerne des nanotubes de carbone, des dispersions de ces nanotubes, des matériaux composites et des articles en matériau composite comprenant ces nanotubes de carbone. Elle concerne également les procédés de fabrication de tels produits.

Dans le contexte de la présente invention le terme "nanotube" désigne un matériau à base de carbone comme les nanofibres de carbone droites et courbées, les nanotubes de carbone qui peuvent être mono-feuillets (SWNT), droits et courbés, ou double-feuillets (DWNT), droits et courbés, ou multi-feuillets (MWNT) droits et courbés aussi bien que les fibres de carbone dont la croissance a été effectuée en phase vapeur (VGCF) et toutes les structures carbonées cylindriques ou tubulaires. Dans ce qui suit, on désignera par les termes "nanotubes muti-feuillets" aussi bien les nanotubes double-feuillets que les nanotubes constitués de trois feuillets et plus. Le terme "nanotube" désigne également un mélange de nanotubes de carbone avec un ou plusieurs composants, tels que le carbone amorphe, le graphite ou un catalyseur (forme sous laquelle on retrouve les nanotubes après production).

Depuis leur découverte en 1991 (Iijima, S., Nature 354 (1991), 56-58) et grâce à leurs propriétés uniques, les nanotubes de carbone ont rapidement suscité l'intérêt des chercheurs. Leurs exceptionnelles élasticité et résistance à la traction, leurs très bonnes conductivités électrique et thermique ainsi que leurs stabilités chimique et thermique ouvrent aux nanotubes de nombreuses applications potentielles dans des secteurs aussi variés que l'électronique, le médical ou l'aéronautique.

Les propriétés des nanotubes de carbone ont été décrites de manière assez exhaustive dans le passé (R. Saito, G. Dresselhaus, M. S. Dresselhaus, "Physical Properties of Carbon Nanotubes", Imperial College Press, London U.K. 1998; J.-B. Donnet, T. K. Wang, J. C. M. Peng, S. Rebouillat [édi.], "Carbon Libers", Marcel Dekker N.Y; USA 1998).

Les nanotubes de carbone mono-feuillets (SWNT) sont généralement synthétisés par des méthodes physiques (arc électrique ou laser) alors que les nanotubes de carbone multi-feuillets (MWNT) sont produits à partir d'une méthode chimique comprenant une décomposition de gaz hydrocarbures.

Le diamètre des nanotubes varie d'environ 0,4 nm à plus de 3 nm pour les SWNT et d'environ 1,4 nm à au moins 100 nm pour les MWNT (Z. K. Tang et al., Science 292, 2462 (2001) ; R. G. Ding, G. Q. Lu, Z. F. Yan, M. A. Wilson, J. Nanosci. Nanotechnol. 1, 7 (2001)).

Certains travaux ont également mis en évidence que l'incorporation de nanotubes de carbone dans des matières plastiques solides permet d'améliorer les propriétés mécaniques et électriques de ces matières plastiques solides (M. J. Biercuk et al., Appl. Phys.Lett. 80, 2767 (2002) ; D. Qian, E. C. Dickey, R. Andrews, T. Randell, Appl. Phys. Lett. 76, 2868 (2000)).

Les propriétés des nanotubes de carbone permettent de les utiliser pour des émetteurs d'électrons, des membranes ou des pointes pour la microscopie par force atomique.

De plus, les nanotubes peuvent contribuer à éviter un chargement électrostatique local, comme cela est observé pendant l'application de peinture sous forme de poudre sur une surface métallique ou plastique.

Afin de permettre une transmission des propriétés favorables des nanotubes de carbone au matériau solide auquel ils sont ajoutés, il est nécessaire d'arriver à répartir les nanotubes de manière homogène dans la matrice dont le matériau est constitué. Pour cela, il faut d'abord préparer des dispersions de nanotubes de carbone dans un milieu liquide. Pour que de telles dispersions soient stables, c'est-à-dire qu'il n'y ait pas d'agrégation ou de précipitation des nanotubes dans le milieu liquide, les forces adhésives entre les particules doivent être minimisées. En effet, les SWNT ainsi que les MWNT ont tendance à s'assembler sous forme de faisceaux contenant plusieurs nanotubes.

A cet effet, le demande de brevet WO02/076888 A1 décrit des suspensions de nanotubes de carbone dans un milieu liquide contenant jusqu'à 65 % en poids de tubes de carbone revêtus de polymères. Cependant, ces suspensions sont uniquement des suspensions soit dans de l'eau pure soit dans des solutions aqueuses.

Or, il est nécessaire, en particulier, pour fabriquer des matériaux composites contenant des nanotubes d'obtenir des dispersions de nanotubes dans des solvants organiques liquides non solubles dans, ou non miscibles avec, l'eau.

Le brevet US 6 099 965 décrit de telles suspensions dans des solvants organiques, éventuellement en présence d'un dispersant, mais la concentration en nanotubes de carbone dans ces suspensions en milieu liquide organique ne dépasse pas 0,1 % en poids.

Le brevet US 6 187 823 B1 décrit des solutions de nanotubes de carbone dissous dans un solvant organique. Mais d'une part, les nanotubes de carbone sont des nanotubes mono-feuillets qui ont été modifiés par attache à leur surface d'une amine ou d'une alkylarylamine et d'autre part, les propriétés intrinsèques des nanotubes sont altérées du fait de leur modification chimique en surface et de la destruction des liaisons carbone-carbone par greffage de groupes amine sur la structure.

En résumé, il existe actuellement des méthodes pour disperser des nanotubes dans des solvants aqueux en concentrations supérieures à 10 % mais aucune permettant de disperser des quantités supérieures à 0,1 % en poids dans des solvants organiques non solubles dans, ou non miscibles avec, l'eau sans modifier chimiquement les nanotubes.

L'impossibilité actuelle de pouvoir disperser de telles quantités de nanotubes dans des solvants organiques non solubles dans, ou non miscibles avec, l'eau et par la suite d'intégrer ces nanotubes de manière homogène dans une matrice organique non miscible ou non soluble dans l'eau constitue un frein à l'utilisation de nanotubes de carbone comme charge.

L'invention vise à pallier les inconvénients de l'art antérieur en proposant de diminuer les interactions interparticulaires entre les nanotubes en les complexant afin d'obtenir des dispersions stables, homogènes et à concentration élevée de nanotubes de carbone, dans des milieux organiques non-miscibles dans l'eau.

Par dispersion stable, dans le cadre de la présente invention, il faut comprendre des dispersions ne présentent ni réagrégation ni reprécipitation des nanotubes de carbone dans la dispersion au bout d'au moins quatre jours de stockage à température ambiante.

Par répartition de manière homogène des nanotubes dans la dispersion, dans le cadre de la présente invention, il faut comprendre que les nanotubes ne forment que peu ou pas d'agrégats et qu'au cas où de tels agrégats sont formés, ces agrégats sont de préférence très petits : inférieurs à 1 µm², et qu'ils sont répartis dans l'ensemble de la dispersion.

Par nanotubes "nus", dans le cadre de la présente invention, il faut comprendre des nanotubes n'ayant subi aucun traitement de modification de leur surface, que ce soit chimique ou par complexation.

Ainsi, un premier objet de l'invention concerne des nanotubes de carbone complexés constitués de nanotubes de carbone nus comportant une couche d'au moins un pigment directement adsorbée sur leur périphérie externe, et au moins un polymère ayant au moins un point d'ancrage sur ladite couche d'au moins un pigment.

Selon l'invention, les nanotubes peuvent être des nanotubes mono-feuillets (SWNT), des nanotubes double-feuillets (DWNT), des nanotubes multi-feuillets (MWNT), des nanotubes dont la croissance a été effectuée en phase vapeur (VGCF), des nanofibres, ou une structure carbonée cylindrique et leurs mélanges.

De préférence, les nanotubes sont des nanotubes mono-feuillets, des nanotubes double-feuillets, des nanotubes multi-feuillets ou leurs mélanges.

Encore plus préférablement, les nanotubes sont des nanotubes mono-feuillets.

Quant au pigment, il peut être un pigment inorganique traité afin d'être compatible avec un polymère ou un solvant organique, ou encore un pigment organique, tel que les pigments azo, les pigments monoazo jaune et orange, les pigments diazo, les pigments napthol, les pigments napthol AS (napthol rouge) les laques de pigment azo, les pigments benzimidazolone, les pigments de condensation diazo, les pigments complexes de métal, les pigments isoindolinone et isoindoline, les pigments polycycliques, les pigments phthalocyanine, une phthalocyanine de cuivre sulfonée contenant, en moyenne, 0,5 à 3 groupes d'acide sulfonique, une pthalocyanine de cuivre chlorée broyée, une phthalocyanine d'aluminium, une phthalocyanine bromée, une pthalocyanine d'hydroxyde d'aluminium, une pthalocyanine sans métal, les pigments quinophthalone, les pigments indanthrone, les pigments diarylide jaune, les pigments diazopyrozolione, les pigments azo-métal, les pigments triarylcarbonium, les pigments rhodamine laque, les pigments pérylène, les pigments quinacridone et les pigments dicétopyrrolopyrrole et les mélanges de deux ou plus de ceux-ci.

De préférence, le pigment est la phtalocyanine.

Quant au polymère, il est choisi dans le groupe constitué par les polymères d'un ou plusieurs acides organiques ou acides hydroxyliques organiques et leurs dérivés, les polymères d'amines, d'alcools ou de thiols organiques, les copolymères ou copolymères blocs d'un ou plusieurs acides organiques et d'une ou plusieurs polyamines, polyalcools ou polythiols organiques, les copolymères du styrène avec l'éthylène, les copolymères du styrène avec le propylène, les copolymères du styrène avec le butadiène, les copolymères du styrène avec les acrylates, les copolymères du styrène avec les méthacrylates et les combinaisons de deux ou plus de ceux-ci.

De préférence, ledit polymère est un copolymère bloc d'acide hydroxyoctadécanoïque et d'aziridine.

Dans un mode de réalisation préféré, le rapport en poids nanotubes / pigment / polymère est compris entre 1/1/1 et 1/5/1.

Avantageusement, le rapport en poids nanotubes / pigment / polymère est de 1/2/1.

Un second objet de l'invention est une dispersion stable de nanotubes de carbone comprenant les nanotubes selon le premier objet de l'invention uniformément répartis dans un solvant organique dans lequel ledit au moins un polymère est soluble.

Le solvant organique est choisi dans le groupe constitué par les hydrocarbures aliphatiques, l'heptane, l'octane, le décane, les hydrocarbures aromatiques, le benzène, le toluène, l'éthylebenzène, le xylène, les hydrocarbures aromatiques et aliphatiques halogénés, le monochlorobenzène, le dichlorobenzène, le dichloroéthylène, le trichloroéthylène, le perchloroéthylène, le tétrachlorocarbone, les acétates, l'acétate de méthyle, l'acétate d'éthyle, l'acétate d'isopropyle, l'acétate de butyle, les cétones, la diisobutylcétone, la diisopropylcétone, la méthylpropylcétone et les mélanges de deux ou plus de ceux-ci.

De préférence, le solvant organique est le xylène.

Dans un mode de réalisation préféré de la dispersion de l'invention, le pourcentage en poids de nanotubes est compris entre 0,01 et 5 % inclus par rapport au poids total de dispersion, le pourcentage en poids du pigment est compris entre 0,01 et 50 % inclus par rapport au poids total de la dispersion, et le rapport en poids du polymère est compris entre 0,01 et 5 % inclus par rapport au poids total de la dispersion.

Un troisième objet de l'invention est un dispositif pour vaporiser une dispersion de nanotubes selon l'invention qui est constitué d'un récipient muni d'un dispositif de vaporisation contenant la dispersion selon l'invention et un agent propulseur.

Un quatrième objet de l'invention est un procédé de fabrication d'une dispersion de nanotubes de carbone, caractérisé en ce qu'il comprend les étapes suivantes :
a) ajout de nanotubes nus, d'au moins un polymère, et d'au moins un pigment, dans un solvant organique dans lequel le polymère est soluble,
b) mélange de la composition obtenue à l'étape a).

Dans un mode de réalisation préféré du procédé de fabrication d'une dispersion de nanotubes selon le quatrième objet de l'invention, l'étape a) comprend les étapes suivantes :
a₁) mélange des nanotubes et dudit au moins un pigment,
a₂) ajout d'un solvant organique dans lequel le polymère est soluble, au mélange obtenu à l'étape a₁), et
a₃) ajout du au moins un polymère au mélange obtenu à l'étape a₂).

Dans ce cas, de préférence, le mélange de l'étape a₁) s'effectue par broyage.

Dans tous les cas, de préférence, dans le procédé de fabrication d'une dispersion de nanotubes de carbone selon le quatrième objet de l'invention, le mélange de l'étape b) est effectué par sonication à la corne.

Dans une variante du procédé de fabrication d'une dispersion de nanotubes de carbone selon le quatrième objet de l'invention, une étape c) d'évaporation d'une partie du solvant est prévue, après l'étape b).

Dans tous les cas, le procédé de fabrication d'une dispersion de nanotubes de carbone selon l'invention s'applique aux nanotubes mono-feuillets (SWNT), aux nanotubes double-feuillets (DWNT), aux nanotubes multi-feuillets (MWNT), aux nanotubes dont la croissance a été effectuée en phase vapeur (VGCF), aux nanofibres ou à toute structure carbonée cylindrique et à leurs mélanges.

De préférence, les nanotubes sont des nanotubes mono-feuillets, des nanotubes double-feuillets, des nanotubes multi-feuillets ou leurs mélanges.

Plus préférablement, les nanotubes sont des nanotubes mono-feuillets.

Selon une première caractéristique du procédé de fabrication d'une dispersion de nanotubes de carbone selon l'invention, ledit au moins un pigment est choisi dans le groupe constitué par un pigment inorganique traité afin d'être compatible avec un polymère ou un solvant organique, les pigments azo, les pigments monoazo jaune et orange, les pigments diazo, les pigments napthol, les pigments napthol AS (napthol rouge) les laques de pigment azo, les pigments benzimidazolone, les pigments de condensation diazo, les pigments complexes de métal, les pigments isoindolinone et isoindoline, les pigments polycycliques, les pigments phthalocyanine, une phthalocyanine de cuivre sulfonée contenant, en moyenne, 0,5 à 3 groupes d'acide sulfonique, une pthalocyanine de cuivre chlorée broyée, une phthalocyanine d'aluminium, une phthalocyanine bromée, une pthalocyanine d'hydroxyde d'aluminium, une pthalocyanine sans métal, les pigments quinophthalone, les pigments indanthrone, les pigments diarylide jaune, les pigments diazopyrozolione, les pigments azo-métal, les pigments triarylcarbonium, les pigments rhodamine laque, les pigments pérylène, les pigments quinacridone et les pigments dicétopyrrolopyrrole et les mélanges de deux ou plus de ceux-ci.

Dans ce cas, de préférence, ledit au moins un pigment est la phtalocyanine.

Selon une autre caractéristique du procédé de fabrication d'une dispersion de nanotubes de carbone selon l'invention, ledit polymère est choisi dans le groupe constitué par les polymères d'un ou plusieurs acides organiques ou acides hydroxyliques organiques et leurs dérivés, les polymères d'amines, d'alcools ou de thiols organiques, les copolymères ou copolymères blocs d'un ou plusieurs acides organiques et d'une ou plusieurs polyamines, polyalcools ou polythiols organiques, les copolymères du styrène avec l'éthylène, les copolymères du styrène avec le propylène, les copolymères du styrène avec le butadiène, les copolymères du styrène avec les acrylates, les copolymères du styrène avec les méthacrylates et les combinaisons de deux ou plus de ceux-ci.

De préférence, ledit polymère est un copolymère bloc d'acide hydroxyoctadécanoïque et d'aziridine.

Selon un mode de réalisation préféré de l'invention du procédé de fabrication d'une dispersion de nanotubes de carbone selon l'invention, le rapport en poids nanotubes / pigment / polymère est compris entre 1/1/1 et 1/5/1.

Plus préférablement, le rapport en poids nanotubes / pigment / polymère est de 1/2/1.

Selon encore une autre caractéristique du procédé de fabrication d'une dispersion de nanotubes de carbone selon l'invention, le solvant organique est choisi dans le groupe constitué par les hydrocarbures aliphatiques, l'heptane, l'octane, le décane, les hydrocarbures aromatiques, le benzène, le toluène, l'éthylebenzène, le xylène, les hydrocarbures aromatiques et aliphatiques halogénés, le monochlorobenzène, le dichlorobenzène, le dichloroéthylène, le trichloroéthylène, le perchloroéthylène, le tétrachlorocarbone, les acétates, l'acétate de méthyle, l'acétate d'éthyle, l'acétate d'isopropyle, l'acétate de butyle, les cétones, la diisobutylecétone, la diisopropylcétone, la méthylpropylcétone et les mélanges d'un ou plusieurs de ceux-ci.

De préférence, le solvant organique est le xylène.

De manière générale, dans le procédé de fabrication d'une dispersion de nanotubes de carbone selon l'invention, le pourcentage en poids de nanotubes est compris entre 0,01 et 5 % inclus par rapport au poids total de la dispersion, le pourcentage en poids du pigment est compris entre 0,01 et 50 % inclus par rapport au poids total de la dispersion, et le pourcentage en poids du polymère est compris entre 0,01 et 5 % inclus par rapport au poids total de la dispersion.

Un cinquième objet de invention est un procédé de fabrication d'une dispersion de nanotubes de carbone qui consiste à placer les nanotubes selon le premier objet de l'invention sous forme de poudre dans un solvant organique dans lequel le polymère, ancré sur la couche de pigment recouvrant la périphérie externe des nanotubes, est soluble et à mélanger sous agitation le solvant et les nanotubes de l'invention.

Selon une caractéristique de ce procédé de fabrication d'une dispersion de nanotubes de carbone, le solvant organique est choisi dans le groupe constitué par les hydrocarbures aliphatiques, l'heptane, l'octane, le décane, les hydrocarbures aromatiques, le benzène, le toluène, l'éthylebenzène, le xylène, les hydrocarbures aromatiques et aliphatiques halogénés, le monochlorobenzène, le dichlorobenzène, le dichloroéthylène, le trichloroéthylène, le perchloroéthylène, le tétrachlorocarbone, les acétates, l'acétate de méthyle, l'acétate d'éthyle, l'acétate d'isopropyle, l'acétate de butyle, les cétones, la diisobutylcétone, la diisopropylcétone, la méthylpropylcétone et les mélanges de deux ou plus de ceux-ci.

De préférence, le solvant organique est le xylène.

Toujours de préférence, selon le cinquième objet de l'invention, l'étape de mélange sous agitation du solvant organique et des nanotubes est effectuée par sonication à la corne.

Un sixième objet de l'invention est un procédé de fabrication de nanotubes de carbone selon le premier objet de l'invention, caractérisé en ce qu'il comprend les étapes du procédé de fabrication d'une dispersion selon le quatrième ou le cinquième objet de l'invention suivi d'une étape d) d'évaporation totale du solvant.

Un septième objet de l'invention est un matériau composite du type comprenant une matrice organique insoluble dans l'eau et des nanotubes de carbone, caractérisé en ce que les nanotubes de carbone sont des nanotubes selon l'invention.

Un huitième objet de l'invention est l'utilisation des nanotubes selon le premier objet de l'invention, ou obtenus par le procédé selon le sixième objet de l'invention pour la fabrication d'articles en matériau composite.

Un neuvième objet de l'invention est l'utilisation de la dispersion selon le deuxième objet de l'invention, ou obtenue par le procédé selon le quatrième ou le cinquième objet de l'invention pour la fabrication d'articles en matériau composite.

Dans ces deux derniers objets, en particulier, l'article est un film ou une couche mince.

Un dixième objet de l'invention est l'utilisation du dispositif selon le troisième objet de l'invention pour la fabrication de films ou de couches minces.

Un onzième objet de l'invention est un procédé de fabrication d'un article en matériau composite du type comprenant une matrice polymérique insoluble dans, ou non miscible avec, l'eau et des nanotubes de carbone, caractérisé en ce qu'il comprend les étapes de fabrication d'une dispersion de nanotubes selon le procédé objet du quatrième ou cinquième objet de l'invention, suivies d'une étape e) de mise en solution du matériau constituant la matrice polymérique insoluble dans l'eau dans un solvant organique dans lequel le matériau constituant la matrice polymérique est soluble, d'une étape f) de mélange de la solution obtenue à l'étape e) avec la dispersion de nanotubes obtenus par le procédé selon le quatrième ou cinquième objet de l'invention, d'une étape g) de mise en forme de l'article voulu, et
en ce que le solvant utilisé pour fabriquer la dispersion de nanotubes et le solvant utilisé pour dissoudre le matériau constituant la matrice polymérique sont solubles ou miscibles l'un dans l'autre.

De préférence, les deux solvants sont identiques.

Dans ce procédé, la matrice polymérique est choisie dans le groupe constitué par les polymères thermoplastiques, le polystyrène, le poly(méthacrylate de méthyle), le poly(chlorure de vinyle), le polyéthylène, le poly(téréphtalate d'éthylène), le poly(oxyde de méthylène), le polyacrylonitrile, les polyesters, les polyuréthanes, les polyamides, les mélanges et copolymères de deux ou plus de ceux-ci.

De préférence, la matrice polymérique est un polyamide

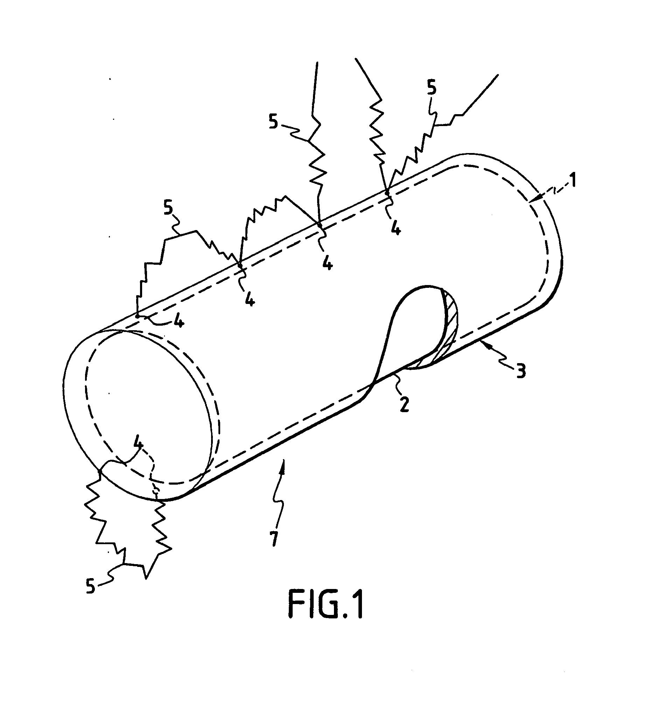

L'invention sera mieux comprise et d'autres avantages et caractéristiques de celle-ci apparaîtront plus clairement à la lecture de la description explicative qui suit qui est faite en référence aux figures annexées dans lesquelles :
- ia figure 1 représente une vue en perspective partiellement arrachée d'un nanotube selon l'invention,
- la figure 2 représente une photographie au microscope optique à un grossissement de 60 d'une dispersion selon l'invention notée XFF09 dans la description qui suit,
- la figure 3 représente une photographie au microscope optique à un grossissement de 60 d'une autre dispersion selon l'invention notée XFF05 dans la description qui suit, et
- la figure 4 représente une photographie au microscope optique un grossissement de 60 d'une dispersion ne tombant pas dans le cadre de l'invention notée XFF010 dans la description qui suit.

Dans la description, les revendications et les figures qui suivent, la référence numérique 1 désigne des nanotubes de carbone "nus" comme défini ci-dessus, la référence numérique 2 désigne la périphérie externe de ces nanotubes 1 en contact, soit avec l'air, soit avec le(s) solvant(s), ou la matrice polymérique, avant leur traitement selon l'invention et la référence numérique 7 désigne les nanotubes de carbone "complexés" selon l'invention.

Les nanotubes de carbone "complexés" selon l'invention seront d'abord décrits en référence à la figure 1.

Comme on le voit en figure 1, le nanotube de carbone "nu" tel qu'il peut être acheté dans le commerce et non traité selon l'invention est noté 1 et le nanotube selon l'invention est noté 7.

Le nanotube 7 est donc constitué du nanotube "nu" 1 que l'on a recouvert d'une couche d'au moins un pigment 3. La couche de pigment 3 est adsorbée sur la surface périphérique externe notée 2 du nanotube 1.

La couche de pigment 3 recouvre uniquement la surface externe des nanotubes.

En effet, les nanotubes sont constitués d'une feuille de graphite enroulée sur elle-même. Cependant, ce tube est "bouché" aux extrémités par deux demi-sphères ce qui rend l'intérieur du nanotube inaccessible pour le(s) pigment(s) et pour le(s) polymère(s). Le pigment 3 s'adsorbe donc uniquement sur la périphérie externe des nanotubes puisque c'est la seule surface qui peut être en contact avec le pigment 3.

De plus, le nanotube 7 selon l'invention comporte au moins un polymère 5 lié à la couche de pigment 3 par au moins un point d'ancrage noté 4.

Comme on peut le voir en figure 1, le polymère 5 peut avoir un seul point d'ancrage 4 sur la couche de pigment 3 ou peut en avoir plusieurs, le reste de la chaîne du polymère 5 flottant librement et recouvrant et protégeant la totalité du nanotube par encombrement stérique.

Bien que ne souhaitant pas être lié par la théorie, on pense que le pigment 3 est lié aux nanotubes de carbone et que le polymère 5 est lié à la couche de pigment 3, par des interactions de type Van der Walls.

C'est pourquoi on entend ici, par "complexation" une interaction sans liaison chimique.

Le polymère 5 peut être un homopolymère ou un copolymère linéaire ou ramifié, de préférence un copolymère bloc.

Des exemples de polymère 5 d'un ou plusieurs acides organiques ou acides hydroxyliques organiques et leurs dérivés. En particulier, il pourra s'agir des polymères d'amines, d'alcools ou de thiols organiques, des copolymères ou copolymères blocs d'un ou plusieurs acides organiques avec une ou plusieurs polyamines, polyalcools ou polythiols organiques, des copolymères du styrène avec l'éthylène, des copolymères du styrène avec le propylène, des copolymères du styrène avec le butadiène, des copolymères du styrène avec les acrylates, des copolymères du styrène avec les méthacrylates et des combinaisons de deux ou plus de ceux-ci.

De préférence, ledit polymère est un copolymère bloc d'acide hydroxyoctadécanoïque et d'aziridine.

Selon la surface spécifique des nanotubes de carbone "nu" 1, le rapport en poids nanotubes 1 / pigment 3 / polymère 5 pourra varier. Il est de préférence compris entre 1/1/1 et 1/5/1, et encore plus préférablement de 1/2/1.

Les nanotubes de l'invention tels que décrits ci-dessus sont sous forme de poudre et peuvent donc être facilement stockés, transportés et manipulés.

Cependant, pour les utiliser en tant que charge dans une matrice polymérique, il faut, comme on l'a vu précédemment préparer une dispersion stable et à répartition uniforme en nanotubes de carbone.

On rappellera ici, que l'on considère qu'une dispersion est stable lorsqu'il n'y a pas de dépôt au fond du récipient au bout de 4 jours voire plusieurs mois.

Ce dépôt, dans le cadre d'une dispersion non stable, est dû à l'agrégation des particules mises en suspension lors des différents traitements qu'elles ont subis lors de la fabrication de la dispersion, en particulier lors du traitement aux ultrasons.

Par répartition uniforme des nanotubes de carbone, on entend que la répartition des nanotubes de carbone est homogène dans l'ensemble de la dispersion, c'est-à-dire que les nanotubes de carbone sont répartis de façon homogène en tout point de la dispersion.

Ainsi, un critère qui permet d'affiner la notion de "répartition uniforme" des nanotubes de carbone dans la dispersion est la taille des agrégats. Plus ces agrégats sont petits, plus la dispersion est uniforme car il y a moins d'agglomération de nanotubes.

Cependant, une dispersion peut être stable et à répartition uniforme en nanotubes de carbone mais avec uniformité de gros agrégats. Ceci n'est pas le cas préféré, mais accepté dans le cadre de l'invention.

Le cas parfait est une dispersion stable et uniforme avec une répartition homogène dans la dispersion de tous petits agrégats ou pas d'agrégats du tout, auquel cas les nanotubes sont parfaitement individualisés.

Ainsi, par répartition uniforme, on entend une répartition homogène au sein de la dispersion d'agrégats de nanotubes, ces agrégats ne devant pas dépasser une taille limite correspondant à une répartition certes uniforme mais pas homogène.

Ainsi, la taille des agrégats est un critère mais ce critère est à nuancer en fonction de la concentration en nanotubes de la dispersion.

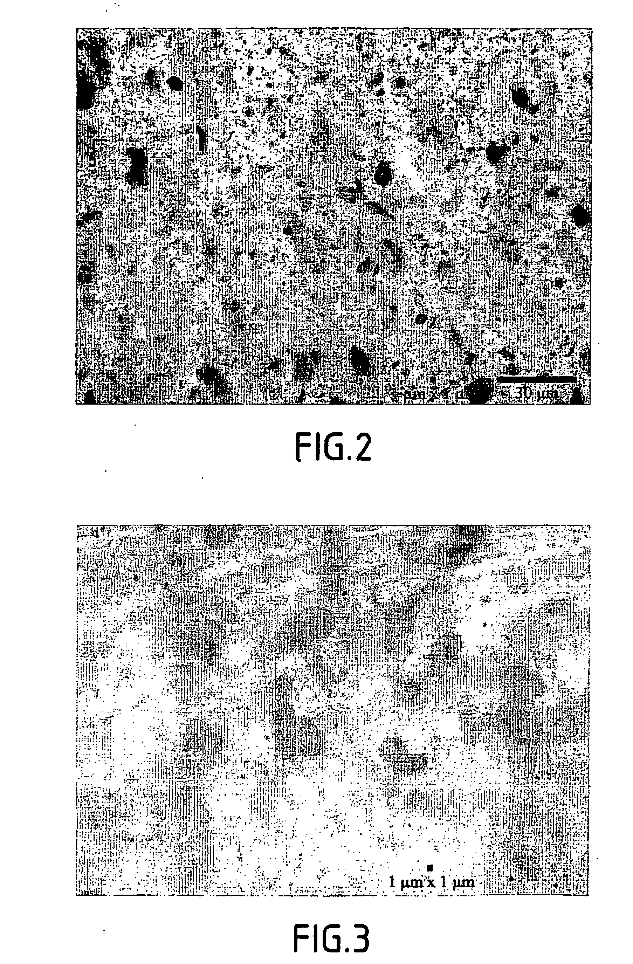

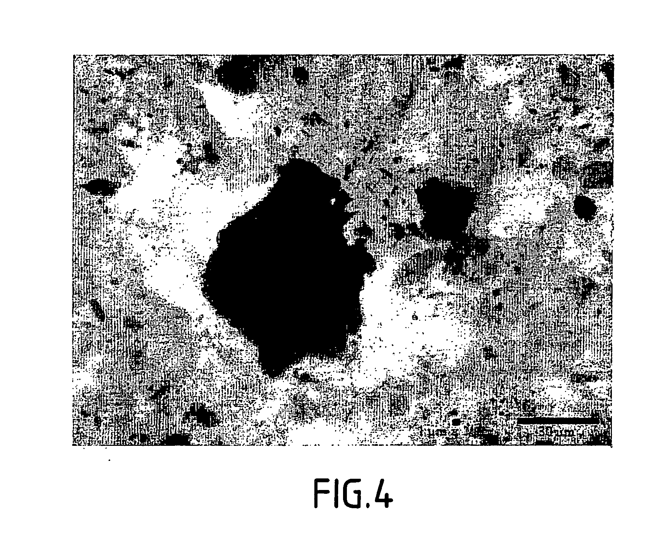

Ainsi, en comparant les figures 2, 3 et 4, on constate sur la figure 2, qu'on a une dispersion à répartition uniforme en nanotubes de carbone avec de très petits agrégats, et sur la figure 3, qu'on a également une dispersion à répartition uniforme en nanotubes avec des agrégats plus gros, et sur la figure 4, qu'on a une dispersion qui n'est pas à répartition uniforme en nanotubes, ces nanotubes étant regroupés en gros agrégats, ce qui fait qu'ils ne sont pas répartis de façon homogène dans toute la dispersion.

Les nanotubes 7 de l'invention peuvent être redispersés dans un solvant organique 6 dans lequel le polymère 5 est soluble, et ce de manière stable, avec une répartition uniforme. Dans ces dispersions, la concentration en poids en nanotubes 7 peut varier entre 0,01 % à 5 % inclus, typiquement de 0,2 % à 5 % en poids, le reste étant le solvant organique.

Le solvant organique 6 est un milieu liquide organique. Il peut s'agir d'un solvant organique polaire ou, plus préférablement d'un solvant organique apolaire. Le terme "apolaire" désigne un liquide organique ou une résine possédant une constante diélectrique ε typiquement inférieur à 9,5.

Des exemples de solvant organique 6 sont les hydrocarbures aliphatiques, l'heptane, l'octane, le décane, les hydrocarbures aromatiques, le benzène, le toluène, l'éthylebenzène, le xylène, les hydrocarbures aromatiques et aliphatiques halogénés, le monochlorobenzène, le dichlorobenzène, le dichloroéthylène, le trichloroéthylène, le perchloroéthylène, le tétrachlorocarbone, les acétates, l'acétate de méthyle, l'acétate d'éthyle, l'acétate d'isopropyle, l'acétate de butyle, les cétones, la diisobutylcétone, la diisopropylcétone, la méthylpropylcétone et les mélanges de deux ou plus de ceux-ci.

Cette redispersion des nanotubes se fait par simple mélange des nanotubes dans le solvant 6 choisi dans lequel le polymère 5 est soluble, à température ambiante.

La dispersion obtenue est stable pendant plusieurs mois et les nanotubes 7 complexés sont répartis uniformément dans cette dispersion, comme on peut le voir en figure 2.

Cependant, une telle dispersion de nanotubes dans le solvant organique 6 défini ci-dessus peut aussi être obtenue directement.

Ainsi, un procédé selon l'invention pour obtenir une dispersion stable de nanotubes de carbone dans le solvant organique 6 comprend les étapes suivantes :
a) ajout de nanotubes 1, d'au moins un polymère 5, d'au moins un pigment 3, dans in solvant organique 6 dans lequel le polymère 5 est soluble,
b) mélange de la composition obtenue à l'étape a).

Dans un mode de réalisation préféré, l'étape a) comprend les étapes suivantes :
a₁) mélange des nanotubes et dudit au moins un pigment 3,
a₂) ajout d'un solvant organique 6 dans lequel le polymère 5 est soluble, au mélange obtenu à l'étape a₁), et
a₃) ajout du au moins un polymère 5, au mélange obtenu à l'étape a₂).

De préférence, le mélange de l'étape b) est effectué par sonication à la corne.

Pour augmenter la concentration en nanotubes de cette dispersion, ce procédé comprend de plus, après l'étape b), une étape c) d'évaporation d'une partie du solvant 6.

Dans ce procédé, les nanotubes 1, 7, le solvant organique 6, le polymère 5 et le pigment 3, entrant dans la composition de ces dispersions, sont les mêmes que ceux précédemment décrits.

De même les proportions et les concentrations en poids de nanotubes de carbone 1, 7, de pigment 3, de polymère 5 et solvant organique 6 sont identiques à celles décrites précédemment.

A partir de cette dispersion, on peut obtenir les nanotubes de l'invention sous forme de poudre, en procédant, après l'étape b) à une évaporation totale du solvant.

Les dispersions de l'invention pourront être utilisées telles quelles pour fabriquer un matériau composite ou un article en matériau composite.

Dans un mode de réalisation particulièrement avantageux de l'invention, les dispersions seront placées dans un récipient comprenant un dispositif de vaporisation et un agent propulseur, tel qu'un gaz, éventuellement un gaz liquéfié. Un tel dispositif sera particulièrement avantageux pour réaliser des films ou des couches minces de nanotubes de carbone.

Dans ce cas, on pourra ajouter à la dispersion de nanotubes de carbone selon l'invention, un agent filmogène ou un liant, telle qu'une résine ou un agent tensioactif.

On observe également au bout de quatre jours et au bout de plusieurs mois, la taille des agrégats de nanotubes de carbone.

Les nanotubes selon l'invention ainsi que les dispersions selon l'invention pourront être utilisés très simplement pour la fabrication de matériaux composite ou d'articles en matériau composite.

Par article en matériau composite, on entend également les films et les couches minces qui pourront également être fabriqués même sans utiliser le dispositif de vaporisation de l'invention.
Un procédé typique de fabrication d'un matériau composite ou d'un article en matériau composite du type comprenant une matrice polymérique insoluble dans l'eau et des nanotubes de carbone comprend les étapes des procédés de fabrication d'une dispersion de nanotubes selon l'invention, suivies de
- une étape e) de mise en solution du matériau constituant la matrice polymérique insoluble dans l'eau dans un solvant organique 7 dans lequel le matériau constituant la matrice polymérique est soluble,
- une étape f) de mélange de la solution obtenue à l'étape e) avec la dispersion de nanotubes obtenue par le procédé selon l'invention, et
- une étape g) de mise en forme de l'article voulu, et le solvant 6 utilisé pour fabriquer la dispersion de nanotubes,
le solvant 7 utilisé pour dissoudre le matériau constituant la matrice polymérique étant solubles l'un dans l'autre.

De préférence, le solvant 6 et le solvant 7 sont identiques.

La matrice polymérique dans laquelle les nanotubes 7 sont ajoutés peut être en tout matériau polymérique insoluble dans l'eau tels que les polymères thermoplastiques, le polystyrène, le poly(méthacrylate de méthyle), le poly(chlorure de vinyle), le polyéthylène, le poly(téréphtalate d'éthylène), le poly(oxyde de méthylène), le polyacrylonitrile, les polyesters, les polyuréthanes, les polyamides, les mélanges et copolymères de deux ou plus de ceux-ci.

Afin de mieux faire comprendre l'invention, on va en décrire maintenant plusieurs modes de réalisation qui ne sont donnés qu'à titre purement illustratifs et non limitatifs.

Tout d'abord, on a fabriqué 17 dispersions de nanotubes de carbone à différentes concentrations en poids en nanotubes 1, en pigment 3, en polymère 5. On a maintenu la quantité de solvant constante, à part pour l'échantillon XF002.

On a ensuite testé les 17 dispersions obtenues quant à la stabilité et à la répartition uniforme des nanotubes de carbone, comme décrit précédemment.

Les nanotubes de carbone utilisés étaient des nanotubes de carbone "nus" fabriqués et commercialisés par la société NANOLEDGE S.A., Montpellier, France.

Le pigment utilisé était un mélange de pigments à base de phtalocyanine commercialisé par la société AVECIA S.A./N.V., Bruxelles, Belgique sous la marque enregistrée Solsperse RTM 5000^{®}.

Le polymère était un copolymère bloc d'acide hydroxyoctadécanoïque et d'aziridine commercialisé par la société AVECIA S.A./N.V., Bruxelles, Belgique sous la marque enregistrée Solsperse RTM 24000SC^{®}. Le solvant était le xylène (mélange d'isomères, puriss.p.a.) commercialisé par SIGMA-ALDRICH CHIMIE S.A.R.L., 38299 Saint Quentin Fallavier Cedex.

On a ensuite observé chacune de ces 17 dispersions au microscope optique, à un grossissement de 60, pour évaluer la présence éventuelle d'agrégats de nanotubes et s'il y avait des agrégats de nanotubes, évaluer la taille de ces agrégats. Cette mesure est représentative de la répartition, uniforme ou non des nanotubes de carbone dans la dispersion.

Dans les tableaux, la taille des agrégats est notée de 1 à 5 :
- la notation 5 correspond à une taille d'agrégats supérieure à 100 000 nm.
- la notation 4 pour la taille des agrégats désigne des agrégats d'une taille inférieure à 100 000 nm mais supérieure à 10 000 nm,
- la notation 3 désigne des agrégats d'une taille inférieure à 10 000 nm mais supérieure à 1 000 nm,
- la notation 2 désigne des agrégats d'une taille inférieure ou égale à 1 000 nm, et
- la notation 1 désigne des agrégats d'une taille inférieure à 1 000 nm, plus préférablement égale à 250 nm.

On l'a vu, plus la taille des agrégats est faible, plus la répartition des nanotubes de carbone dans la dispersion est uniforme.

Puis on a stocké chacune des ces dispersions à température ambiante pendant quatre jours et quatre mois et on les a examinées à nouveau au bout de chacune de ces périodes pour déterminer s'il y avait une précipitation et/ou une réagglomération des nanotubes de carbone

### Exemple comparatif 1 : noté XF001 dans le tableau 1

Dans ce cas, et à titre de comparaison, on a fabriqué une dispersion de nanotubes de carbone sans utilisation de polymère.

On a mélangé par broyage à sec dans un broyeur à bille 10,0 mg de nanotubes "nus" (1) avec 20,0 mg de pigment.

Le rapport en poids de nanotubes 1 / pigment 3/ polymère 5 est ainsi de 1/2/0 dans cet exemple.

Ensuite, on a ajouté à ce mélange 5000,3 mg de xylène et l'on a mélangé en soniquant au bain 2 fois pendant 15 minutes.

### Exemple comparatif 2 : noté XF002 dans le tableau 1

Cette dispersion a également été fabriquée à titre de comparaison.

Dans cet exemple, la dispersion de nanotubes de carbone a été fabriquée sans utiliser de pigment. Ainsi, on a mélangé par broyage à sec dans un broyeur à bille 6,8 mg de nanotubes de carbone nus avec 3,7 mg de polymère. Le rapport en poids nanotubes / pigment / polymère est de 1/0/0,54.

On ajoute à ce mélange 2503,0 mg de solvant et l'on mélange l'ensemble en soniquant au bain 2 fois pendant 15 minutes.

Les résultats de mesure de taille des agrégats et de stabilité sont reportés au tableau 1.

### Exemple comparatif 3 : noté XF010 dans le tableau 1

On mélange par broyage à sec dans un broyeur à bille 10,1 mg de nanotubes nus et 8,4 ma de polymère. Ici, il n'y avait pas de pigment.

Le rapport en poids nanotubes / pigment / polymère est de 1/0/0,83 dans cet exemple.

On ajoute au mélange broyé obtenu 4951,0 mg de xylène et on mélange en soniquant au bain 2 fois pendant 15 minutes.

Les résultats de l'évaluation de la stabilité et de la répartition uniforme des nanotubes dans cette dispersion sont reportés au tableau 1.

### Exemple 1 : noté XF003 dans le tableau 1

On a mélangé par broyage à sec dans un broyeur à bille 9,5 mg de nanotubes de carbone nus, 12,3 mg de pigment et 4,0 mg de polymère soit un rapport en poids nanotubes / pigment / polymère de 1/0,3/0,42.

On ajoute à ce mélange 5000,13 mg de xylène et on mélange en soniquant au bain 2 fois pendant 15 minutes.

Les résultats de l'évaluation de la stabilité et de la répartition uniforme de la dispersion obtenue sont reportés au tableau 1.

### Exemple 2 : noté XF004 dans le tableau 1

On a mélangé 9,8 mg de nanotubes de carbone nus avec 20,3 mg de pigment et 6,1 mg de polymère par broyage à sec dans un broyeur à bille.

Le rapport en poids nanotubes / pigment / polymère est de 1/2,07/0,62.

On ajoute à ce mélange 5000,0 mg de xylène et on mélange en soniquant au bain 2 fois pendant 15 minutes.

Les résultats de l'évaluation de la stabilité et de la répartition uniforme de la dispersion obtenue sont reportés au tableau 1.

### Exemple 3 : noté XF005 dans le tableau 1

On a mélangé 9,9 mg de nanotubes de carbone nus avec 1,0 mg de pigment et 6,8 mg de polymère par broyage à sec dans un broyeur à bille.

Le rapport en poids nanotubes / pigment / polymère est de 1/0,1/0,69.

On ajoute à ce mélange 5035,0 mg de xylène et on mélange en soniquant au bain 2 fois pendant 15 minutes.

Les résultats de l'évaluation de la stabilité et de la répartition uniforme de la dispersion obtenue sont reportés au tableau 1.

### Exemple 4 : noté XF006

On mélange par broyage à sec dans un broyeur à bille 10,4 mg de nanotubes de carbone nus, 32,6 mg de pigment et 8,3 mg de polymère.

Le rapport en poids nanotubes / pigment / polymère est de 1/3,1/0,80 dans cet exemple.

On ajoute au mélange broyé obtenu 5008,0 mg de xylène en soniquant au bain 2 fois pendant 15 minutes.

Les résultats de l'évaluation de la stabilité et de la répartition uniforme des nanotubes dans cette dispersion sont reportés au tableau 1.

### Exemple 5 : noté XF007 dans le tableau 1

On mélange par broyage à sec dans un broyeur à bille 10,3 mg de nanotubes nus, 2,7 mg de pigment et 8,0 mg de polymère.

Le rapport en poids nanotubes / pigment / polymère est de 1/0,26/0,78 dans cet exemple.

On ajoute au mélange broyé obtenu 5008,0 mg de xylène et on mélange en soniquant au bain 2 fois pendant 15 minutes.

Les résultats de l'évaluation de la stabilité et de la répartition uniforme des nanotubes dans cette dispersion sont reportés au tableau 1.

### Exemple 6 : noté XF008 dans le tableau 1

On mélange par broyage à sec dans un broyeur à bille 10,2 mg de nanotubes nus, 3,9 mg de pigment et 8,2 mg de polymère.

Le rapport en poids nanotubes / pigment / polymère est de 1/0,38/0,80 dans cet exemple.

On ajoute au mélange broyé obtenu 5000,2 mg de xylène et on mélange en soniquant au bain 2 fois pendant 15 minutes.

Les résultas de l'évaluation da la stabilité et de la répartition uniforme des nanotubes dans cette dispersion sont reportés au tableau 1.

### Exemple 7 : noté XF009 dans le tableau 1

On mélange par broyage à sec dans un broyeur à bille 10,1 mg de nanotubes nus, 10,0 mg de pigment et 8,4 mg de polymère.

Le rapport en poids nanotubes / pigment / polymère est de 1/1/0,83 dans cet exemple.

On ajoute au mélange broyé obtenu 5010,0 mg de xylène et on mélange en soniquant au bain 2 fois pendant 15 minutes.

Les résultats de l'évaluation de la stabilité et de la répartition uniforme des nanotubes dans cette dispersion sont reportés au tableau 1.

### Exemple 8 : noté XF011 dans le tableau 1

On mélange par broyage à sec dans un broyeur à bille 10,3 mg de nanotubes nus, 1,6 mg de pigment et 8,5 mg de polymère.

Le rapport en poids nanotubes / pigment / polymère est de 1/0,15/0,82 dans cet exemple.

On ajoute au mélange broyé obtenu 4991,0 mg de xylène et on mélange en soniquant au bain 2 fois pendant 15 minutes.

Les résultats de l'évaluation de la stabilité et de la répartition uniforme des nanotubes dans cette dispersion sont reportés au tableau 1.

### Exemple 9 : noté XF012 dans le tableau 1

On mélange par broyage à sec dans un broyeur à bille 9,8 mg de nanotubes nus, 30,5 mg de pigment et 10,2 mg de polymère.

Le rapport en poids nanotubes / pigment / polymère est de 1/3,1/1,04 dans cet exemple.

On ajoute au mélange broyé obtenu 5006,0 mg de xylène et on mélange en soniquant au bain 2 fois pendant 15 minutes.

Les résultats de l'évaluation de la stabilité et de la répartition uniforme des nanotubes dans cette dispersion sont reportés au tableau 1.

### Exemple 10 : noté XF013 dans le tableau 1

On mélange par broyage à sec dans un broyeur à bille 10,3 mg de nanotubes nus, 11,2 mg de pigment et 10,3 mg de polymère.

Le rapport en poids nanotubes / pigment / polymère est de 1/0,1/1 dans cet exemple.

On ajoute au mélange broyé obtenu 5004,0 mg de xylène et on mélange en soniquant au bain 2 fois pendant 15 minutes.

Les résultats de l'évaluation de la stabilité et de la répartition uniforme des nanotubes dans cette dispersion sont reportés au tableau 1.

### Exemple 11 : noté XF014 dans le tableau 1

On mélange par broyage à sec dans un broyeur à bille 9,7 mg de nanotubes nus, 22,7 mg de pigment et 10,5 mg de polymère.

Le rapport en poids nanotubes / pigment / polymère est de 1/2,34/1,08 dans cet exemple.

On ajoute au mélange broyé obtenu 4994,0 mg de xylène et on mélange en soniquant au bain 2 fois pendant 15 minutes.

Les résultats de l'évaluation de la stabilité et de la répartition uniforme des nanotubes dans cette dispersion sont reportés au tableau 1.

### Exempte 12 : noté XF015 dans le tableau 1

On mélange par broyage à sec dans un broyeur à bille 10,3 mg de nanotubes nus, 20,2 mg de pigment et 15,3 mg de polymère.

Le rapport en poids nanotubes / pigment / polymère est de 1/1,96/1,48 dans cet exemple.

On ajoute au mélange broyé obtenu 4994,0 mg de xylène on mélange en soniquant au bain 2 fois pendant 15 minutes.

Les résultats de l'évaluation de la stabilité et de la répartition uniforme des nanotubes dans cette dispersion sont reportés au tableau 1.

### Exemple 13 : noté XF016 dans le tableau 1

On mélange par broyage à sec dans un broyeur à bille 10,3 mg de nanotubes nus, 47,5 mg de pigment et 16,4 mg de polymère.

Le rapport en poids nanotubes / pigment / polymère est de 1/4,61/1,59 dans cet exemple.

On ajoute au mélange broyé obtenu 4995,0 mg de xylène et on mélange en soniquant au bain 2 fois pendant 15 minutes.

Les résultats de l'évaluation de la stabilité et de la répartition uniforme des nanotubes dans cette dispersion sont reportés au tableau 1.

### Exemple 14 : noté XF017 dans le tableau 1

On mélange par broyage à sec dans un broyeur à bille 10,1 mg de nanotubes nus, 20,6 mg de pigment et 33,2 mg de polymère.

Le rapport en poids nanotubes / pigment / polymère est de 1/2/3,3 dans cet exemple.

On ajoute au mélange broyé obtenu 5003,0 mg de xylène et on mélange en soniquant au bain 2 fois pendant 15 minutes.

Les résultats de l'évaluation de la stabilité de la répartition uniforme des nanotubes dans cette dispersion sont reportés au tableau 1.

**TABLEAU 1**

| **Dispersion** | **Poids de nanotubes en mg** | **Poids de pigment en mg** | **Poids de polymère en mg** | **Rapport en poids nanofibres/pigment/polymère** | **Poids de xylène en mg** | **agrégats** |
|---|---|---|---|---|---|---|
| **XF001** | 10,0 | 20,0 | 0 | 1/2/0 | 5000,3 | 5 |
| **XF002** | 6,8 | 0,0 | 3,7 | 1/0/0,5 | 2503,0 | 5 |
| **XF010** | 10,1 | 0,0 | 8,4 | 1/0/0,8 | 4951,0 | 5 |
| **XF003** | 9,5 | 12,3 | 4,0 | 1/1,3/0,4 | 5013,0 | 3 |
| **XF004** | 9,8 | 20,3 | 6,1 | 1/2,1/0,6 | 5000,0 | 3 |
| **XF005** | 9,9 | 1,0 | 6,8 | 1/0,1/0,7 | 5035,0 | 3 |
| **XF006** | 10,4 | 32,6 | 8,3 | 1/3,1/0,8 | 5000,0 | 4 |
| **XF007** | 10,3 | 2,7 | 8,0 | 1/0,26/0,8 | 5008,0 | 3 |
| **XF008** | 10,2 | 3,9 | 8,2 | 1/0,38/0,8 | 5002,0 | 3 |
| **XF009** | 10,1 | 10,0 | 8,4 | 1/1/0,8 | 5010,0 | 3 |
| **XF011** | 10,3 | 1,6 | 8,5 | 1/0,15/0,8 | 4991,0 | 3 |
| **XF012** | 9,8 | 30,5 | 10,2 | 1/3,1/1 | 5006,0 | 2 |
| **XF013** | 10,1 | 11,2 | 10,3 | 1/0,1/1 | 5004,0 | 3 |
| **XF014** | 9,7 | 22,7 | 10,5 | 1/2,34/1,1 | 4994,0 | 1 |
| **XF015** | 10,3 | 20,2 | 15,3 | 1/1,96/1,5 | 4994,0 | 3 |
| **XF016** | 10,3 | 47,5 | 16,4 | 1/4,61/1,6 | 4995,0 | 2 |
| **XF017** | 10,1 | 20,6 | 33,2 | 1/2/2,3 | 5003,0 | 3 |

Toutes les dispersions obtenues en utilisant le pigment et le polymère étaient stables c'est-à-dire ne présentaient ni précipitation ni réagglomération des nanotubes au bout de 4 jours de stockage à température ambiante alors que les dispersions obtenues en utilisant soit le polymère soit le pigment tout seul n'étaient stables que pendant quelques minutes.

Toutes les dispersions stables au bout de 4 jours de stockage à température ambiante l'étaient également au bout de 4 mois. Elles étaient mêmes meilleures, car on a noté dans ce cas une diminution de la taille des agrégats de nanotubes de carbone tout en conservant une répartition uniforme et homogène et sans dépôt au fond du récipient de stockage.

On voit à partir du tableau 1 que les dispersions obtenues sans pigment et sans polymère présentent toutes une taille d'agrégats de 5, ce qui montre qu'elles n'étaient pas à répartition uniforme.

Ainsi, la dispersion sera considérée comme étant à répartition uniforme lorsque la notation attribuée pour taille des agrégats est de 2 ou 1.

On voit à partir du tableau 1 que les dispersions obtenues à l'exemple 10 (noté XF012 dans le tableau 1) à l'exemple 12 (noté XF014 dans le tableau 1) et à l'exemple 14 (noté XF016 dans le tableau 1) permettent d'obtenir une dispersion stable et à répartition uniforme des nanotubes de carbone.

Ainsi, bien que ce rapport puisse varier en fonction de la surface spécifique des nanotubes de carbone nus utilisés pour fabriquer les nanotubes de carbone de l'invention et les dispersions de nanotubes de carbone nus utilisés pour fabriquer les nanotubes de carbone de l'invention et les dispersions de nanotubes de carbone de l'invention, les rapports préférés en poids nanotubes / pigment / polymère sont compris entre 1/5/1 et 1/2/1 avec les meilleurs résultats étant obtenus avec un rapport en poids nanotubes / pigment / polymère de 1/2/1.

Les essais suivants ont visé à trouver la meilleure méthode de fabrication des dispersions et des nanotubes selon l'invention.

Pour ces essais, on a maintenu le rapport en poids nanotubes / pigment / polymère constant c'est-à-dire à un rapport de 1/2/1.

On a fait varier la quantité de solvant, de pigment ainsi que la méthode de mélange du pigment aux nanotubes de carbone et au polymère, dans le solvant.

Quatorze nouvelles dispersions ayant toutes un rapport en poids nanotubes / pigment / polymère de 1/2/1 ont été préparées.

Les nanotubes nus, le pigment, le polymère et le solvant utilisés pour réaliser ces dispersions sont les mêmes que ceux utilisés pour la fabrication des dispersions XF001 à XF017 décrites ci-dessus.

Les différents poids de nanotubes, de pigment et de polymère ainsi que de solvant, en mg, sont reportés au tableau 2 ci-après.

La concentration finale, en poids, de nanotubes dans la dispersion obtenue est également reportée au tableau 2 ainsi que les résultats de l'évaluation de la stabilité et de la répartition uniforme des nanotubes dans la dispersion.

Les conditions opératoires pour fabriquer ces dispersions sont indiquées au tableau 3.

Dans le tableau 3 :
- BM indique que le mélange nanotubes / pigment / polymère, qu'il soit effectué en une seule étape a) ou en trois étapes notées a₁) a₂) et a₃) dans la description qui précède, a été effectué par broyage à la main dans un mortier en porcelaine, et que le broyage de ces poudres a eu lieu en rajoutant quelques gouttes de solvant.
- BBS indique que le mélange nanotubes / pigment / polymère ou nanotubes / pigment a été effectué par broyage à sec, sans solvant, dans un vibro-broyeur automatique Retsch MM 2000 Bioblock Scientific, Illkirch, France, puissance 600 Watt, fréquence 20 kHz dans lequel était placé une seule bille en acier, en réutilisant un réglage de l'amplitude de 70 et pendant la durée spécifiée an tableau 3.
- BBH indique que le mélange nanotubes / pigment / polymère ou nanotubes / pigment a été effectué dans le même broyeur que précédemment, dans les mêmes conditions, sauf que les poudres de départ sont mouillées avec quelques gouttes de solvant.

Le mélange nanotubes-pigment ou nanotubes-pigment-polymère est ensuite additionné de la totalité du solvant et mélangé pendant la durée indiquée au tableau 3. Ce mélange est effectué soit par une sonication au bain notée SB, soit par une sonication à la corne notée SC au tableau 3.

La sonication au bain correspond au traitement par ultrasons de la dispersion, les ultrasons étant générés dans un bain DELTASONIC P500 S/R. La dispersion est contenue dans un récipient et plongée dans un bain d'eau distillée, les ultrasons sont transmis à l'échantillon au travers du bain. La durée du traitement est spécifiée au tableau 3.

Le traitement de sonication à la corne correspond à un traitement de la dispersion avec des ultrasons générés par une corne. L'appareillage utilisé est un appareil BIOBLOCK SCIENTIFIC VIBRACELL 75455 avec une impulsion de valeur 4 et une amplitude de valeur 60. La dispersion est contenue dans un récipient en verre qui est plongé dans un bain d'eau distillée. La fonction du bain est exclusivement de refroidir l'échantillon pendant l'application des ultrasons et non de transmettre l'énergie. En fait, la corne génératrice des ultrasons est plongée directement dans la dispersion et les ultrasons sont appliqués directement.

Dans certains cas, une étape d'évaporation partielle du solvant a été effectuée pour concentrer la dispersion. Pour ce faire, la dispersion est placée dans un récipient en verre résistant à la chaleur et réchauffé à l'aide d'une plaque chauffante munie d'un mélangeur magnétique. Le chauffage est maintenu pendant le temps spécifié au tableau 3, en même temps, tout en agitant l'échantillon. La durée de l'agitation notée A au tableau 3 est indiquée au tableau 3.

Pour optimiser ces conditions, on a de plus effectué l'essai suivant :

### EXEMPLE 15 : Echantillon XFF013

On mélange par broyage en milieu humide dans un broyeur à billes : 25,2 mg de nanotubes nus, 50,8 mg de pigment et 524,3 mg de xylène.

On ajoute au mélange broyé obtenu 4483,1 mg de xylène et on applique un traitement de sonication à la corne pendant 30 minutes au mélange obtenu.

On ajoute ensuite 25,8 mg de polymère.

Le rapport en poids nanotubes / pigment / polymère est de 1/2/1.

On évapore ensuite 4605,2 mg de xylène. La dispersion ainsi obtenue a une concentration en % en poids de nanotubes, par rapport au poids total de la dispersion de 5 % et reste stable pendant plusieurs mois.

**TABLEAU 2**

| **Echantillon** | **Poids de nanotubes en mg** | **Poids de pigment en mg** | **Poids de polymère en mg** | **Poids de xylène en mg** | **Concentration finale en % en poids de nanotubes** | **Agrégats** |
|---|---|---|---|---|---|---|
| **XFF001** | 10,01 | 23,00 | 10,90 | 5000 | 0,2 | 4 |
| **XFF002** | 100,00 | 230,00 | 100,00 | 5000 | 1,9 | 4 |
| **XFF003** | 50,70 | 104,00 | 59,00 | 5000 | 1,0 | 4 |
| **XFF004** | 100,70 | 202,00 | 100,00 | 5000 | 1,9 | 4 |
| **XFF005** | 50,10 | 115,00 | 55,00 | 5000 | 1,0 | 3 |
| **XFF006** | 52,00 | 102,00 | 50,00 | 5000 | 1,0 | 3 |
| **XFF007** | 25,00 | 54,00 | 25,00 | 5000 | 0,5 | 2 |
| **XPF008** | 300,00 | 600,00 | 300,00 | 15000 | 1,9 | 3 |
| **XFF009** | 66,00 | 136,00 | 69,00 | 3300 | 1,8 | 2 |
| **XFF010** | 200,00 | 400,00 | 202,00 | 10000 | 1,9 | 5 |
| **XFF011** | 150,00 | 300,00 | 165,00 | 7500 | 1,9 | 3 |
| **XFF012 a** | 200,85 | 403,04 | 198,36 | 38970 | 0,5 | 2 |
| **XFF012 b** | 401,71 | 806,09 | 396,71 | 38970 | 1,0 | 3 |
| **XFF012 c** | 803,43 | 612,17 | 793,43 | 38970 | 2,0 | 3 |
| **XFF013** | 25,2 | 50,5 | 25,8 | 402 | 5,0 | 3 |

**TABLEAU 3**

| | **BM** | **BBS** | **BBH** | **SB** | **SC** | **E** | **A** |
|---|---|---|---|---|---|---|---|
| **XFF001** | 2 min | | | 30 min | | | |
| **XFF002** | 2 min | | | 30 min | | | |
| **XFF003** | 2 min | | | | | | 750 min |
| **XFF004** | 2 min | | | | | | 750 min |
| **XFF005** | 2 min | | | | 30 min | X | |
| **XFF006** | 2 min | | | | | X | |
| **XFF007** | | | | | 60 min | X | |
| **XFF008** | 2 min | | | | 60 min | | |
| **XFF009** | | 3 min | | | 30 min | X | 840 min |
| **XFF010** | | | 3 min | | 30 min | X | |
| **XFF011** | | | 5 min | | 60 min | X | |
| **XFF012 a** | | | 3 min | | 75 min | | |
| **XFF012 b** | | | 3 min | | 75 min | X | |
| **XFF012 c** | | | 3 min | | 75 min | x | |
| **XFF013** | | | 3 min | | 30 min | X | |

Les résultats de l'évaluation de la stabilité et de la répartition uniforme des nanotubes dans les dispersions obtenues montrent que seules les dispersions XFF009, XFF007 et XFF005 sont des dispersions non seulement stables mais également à répartition uniforme en nanotubes de carbone, comme on peut le voir en comparant les figures 2, 3 et 4 qui montrent des photographies prises au microscope optique à un grossissement de 60 de la dispersion XFF005 (figure 2) et la dispersion XFF009 (figure 3) et de la dispersion XFF010 (figure 4).

On voit que la taille des agrégats dans la dispersion XFF005 et XFF009 sont nettement plus faibles que la taille des agrégats dans la dispersion XFF010, ce qui dénote une répartition uniforme des nanotubes de carbone dans les dispersions XFF005 et XFF009 contrairement à la dispersion XFF010. C'est pour cette raison que l'on considère qu'un traitement aux ultrasons à la corne en combinaison avec un broyage dans un broyeur à bille, de préférence en milieu humide, suivi d'une évaporation partielle du solvant est la meilleure méthode pour obtenir des dispersions stables concentrées et à répartition uniforme de nanotubes.

On notera également que plus la concentration en nanotubes de carbone est faible, plus les agrégats sont petits. Cependant, on voit à partir de l'exemple 15, qu'on arrive à augmenter la concentration en nanotubes "nus" jusqu'à au moins 5 % en poids par rapport au poids total de la dispersion en obtenant une dispersion satisfaisante, dans un solvant organique.

On a ensuite, à partir de la dispersion XFF013, réalisé une évaporation complète du solvant.

On obtient une poudre constituée de nanotubes séparés. Le mélange peut être redispersé en ajoutant, par exemple 5 ml de xylène sous agitation forte. La dispersion ainsi obtenue est stable et à répartition uniforme.

On a utilisé la dispersion ainsi obtenue pour fabriquer des fibres en polyamide chargées en nanotubes de carbone. Pour ce faire, le polyamide a été dissous dans du xylène, la dispersion de nanotubes obtenue précédemment a été mélangée au polyamide dissous dans le xylène, et le mélange obtenu a été extrudé.

## Revendications

1. Nanotubes de carbone (7), **caractérisés en ce qu'**ils sont constitués de nanotubes (1) comportant :
- une couche d'au moins un pigment (3) directement adsorbée sur leur périphérie externe (2), et
- au moins un polymère (5) ayant au moins un point d'ancrage (4) sur ladite couche d'au moins un pigment (3).

2. Nanotubes de carbone (7) selon la revendication 1, **caractérisés en ce que** les nanotubes (1) sont choisis dans le groupe constitué par les nanotubes mono-feuillets (SWNT), les nanotubes double-feuillets (DWNT), les nanotubes multi-feuillets (MWNT), les nanotubes dont la croissance a été effectuée en phase vapeur (VGCF), les nanofibres ou une structure carbonée cylindrique et leurs mélanges.

3. Nanotubes de carbone (7) selon la revendication 1, **caractérisés en ce que** les nanotubes (1) sont choisis dans le groupe constitué par les nanotubes multi-feuillets, les nanotubes double-feuillets, les nanotubes mono-feuillet et leurs mélanges.

4. Nanotubes de carbone (7) selon la revendication 1, **caractérisés en ce que** les nanotubes (1) sont des nanotubes mono-feuillets.

5. Nanotubes de carbone (7) selon l'une quelconque des revendications précédentes, **caractérisés en ce que** ledit au moins un pigment (3) est choisi dans le groupe constitué par les pigments inorganiques traités afin d'être compatibles avec un polymère ou un solvant organique, les pigments azo, les pigments monoazo jaune et orange, les pigments diazo, les pigments napthol, les pigments napthol AS (napthol rouge) les laques de pigment azo, les pigments benzimidazolone, les pigments de condensation diazo, les pigments complexes de métal, les pigments isoindolinone et isoindoline, les pigments polycycliques, les pigments phthalocyanine, une phthalocyanine de cuivre sulfonéee contenant, en moyenne, 0,5 à 3 groupes d'acide sulfonique, une pthalocyanine de cuivre chlorée, une phthalocyanine d'aluminium, une phthalocyanine bromée, une pthalocyanine d'hydroxyde d'aluminium, une pthalocyanine sans métal, les pigments quinophthalone, les pigments indanthrone, les pigments diarylide jaune, les pigments diazopyrozolione, les pigments azo-métal, les pigments triarylcarbonium, les pigments rhodamine laque, les pigments pérylène, les pigments quinacridone et les pigments dicétopyrrolopyrrole et les mélanges de deux ou plus de ceux-ci.

6. Nanotubes de carbone (7) selon l'une quelconque des revendications précédentes, **caractérisés en ce que** ledit au moins un pigment (3) est la phtalocyanine.

7. Nanotubes de carbone (7) selon l'une quelconque des revendications précédentes, **caractérisés en ce que** ledit polymère (5) est choisi dans le groupe constitué par les polymères d'un ou plusieurs acides organiques ou acides hydroxyliques organiques et leurs dérivés, les polymères d'amines, d'alcools ou de thiols organiques, les copolymères ou copolymères blocs d'un ou plusieurs acides organiques et d'une ou plusieurs polyamines, polyalcools ou polythiols organiques, les copolymères du styrène avec l'éthylène, les copolymères du styrène avec le propylène, les copolymères du styrène avec le butadiène, les copolymères du styrène avec les acrylates, les copolymères du styrène avec les méthacrylates et les combinaisons de deux ou plus de ceux-ci.

8. Nanotubes de carbone (7) selon l'une quelconque des revendications précédentes, **caractérisés en ce que** ledit polymère (5) est un copolymère bloc d'acide hydroxyoctadécanoïque et d'aziridine.

9. Nanotubes de carbone (7) selon l'une quelconque des revendications précédentes, **caractérisés en ce que** le rapport en poids nanotubes (1) / pigment (3) / polymère (5) est compris entre 1/1/1 et 1/5/1.

10. Nanotubes de carbone (7) selon l'une quelconque des revendications précédentes, **caractérisés en ce que** le rapport en poids nanotubes (1) / pigment (3) / polymère (5) est de 1/2/1.

11. Dispersion de nanotubes de carbone (7), **caractérisée en ce qu'**elle comprend les nanotubes (7) selon l'une quelconque des revendications précédentes répartis uniformément et de façon stable dans un solvant organique (6) dans lequel ledit au moins un polymère (5) est soluble.

12. Dispersion selon la revendication 11, **caractérisée en ce que** le solvant organique (6) est choisi dans le groupe constitué par les hydrocarbures aliphatiques, l'heptane, l'octane, le décane, les hydrocarbures aromatiques, le benzène, le toluène, l'éthylebenzène, le xylène, les hydrocarbures aromatiques et aliphatiques halogénés, le monochlorobenzène, le dichlorobenzène, le dichloroéthylène, le trichloroéthylène, le perchloroéthylène, le tétrachlorocarbone, les acétates, l'acétate de méthyle, l'acétate d'éthyle, l'acétate d'isopropyle, l'acétate de butyle, les cétones, la diisobutylcétone, la diisopropylcétone, la méthylpropylcétone et les mélanges de deux ou plus de ceux-ci.

13. Dispersion selon la revendication 11 ou 12, **caractérisée en ce que** le solvant organique (6) est le xylène.

14. Dispersion selon l'une quelconque des revendications 11 à 13, **caractérisée en ce que** :
- le pourcentage en poids de nanotubes (1) est compris entre 0,01 et 5 % inclus par rapport au poids total de la dispersion,
- le pourcentage en poids du pigment (3) est compris entre 0,01 et 50 % inclus par rapport au poids total de la dispersion, et
- le pourcentage en poids du polymère (5) est compris entre 0,01 et 5 % inclus par rapport au poids total de la dispersion.

15. Composition **caractérisée en ce qu'**elle comprend la dispersion selon l'une quelconque des revendications 11 à 14 et un agent propulseur.

16. Procédé de fabrication d'une dispersion de nanotubes de carbone (7), **caractérisé en ce qu'**il comprend les étapes suivantes :
a) ajout des nanotubes (1), d'au moins un polymère (5) et d'au moins un pigment (3), dans un solvant organique (6) dans lequel le polymère (5) est soluble,
b) mélange de la composition obtenue à l'étape a).

17. Procédé de fabrication d'une dispersion de nanotubes de carbone (7) selon la revendication 16, **caractérisé en ce que** l'étape a) comprend les étapes suivantes :
a₁) mélange des nanotubes (1) et dudit au moins un pigment (3), a₂) ajout d'un solvant organique (6) dans lequel le polymère (5) est soluble, au mélange obtenu à l'étape a₁), et
a₃) ajout du au moins un polymère (5), au mélange obtenu à l'étape a₂).

18. Procédé de fabrication d'une dispersion de nanotubes de carbone (7) selon la revendication 17, **caractérisé en ce que** le mélange de l'étape a₁) s'effectue par broyage.

19. Procédé de fabrication d'une dispersion de nanotubes de carbone (7) selon l'une quelconque des revendications 16 à 18, **caractérisé en ce que** le mélange de l'étape b) est effectué par sonication à la corne.

20. Procédé de fabrication d'une dispersion de nanotubes de carbone (7) selon l'une quelconque des revendications 16 à 19, **caractérisé en ce qu'**il comprend de plus, après l'étape b), une étape c) d'évaporation d'une partie du solvant (6).

21. Procédé de fabrication d'une dispersion de nanotubes de carbone (7) selon l'une quelconque des revendications 16 à 20, **caractérisé en ce que** les nanotubes (1, 7) sont choisis dans le groupe constitué par les nanotubes mono-feuillets (SWNT), les nanotubes double-feuillets (DWNT), les nanotubes multi-feuillets (MWNT), les nanotubes dont la croissance a été effectuée en phase vapeur (VGCF), les nanofibres ou une structure carbonée cylindrique et leurs mélanges.

22. Procédé de fabrication d'une dispersion de nanotubes de carbone (7) selon l'une quelconque des revendications 16 à 21, **caractérisé en ce que** les nanotubes (1) sont choisis dans le groupe constitué par les nanotubes multi-feuillets (MWNT), les nanotubes double-feuillets, les nanotubes mono-feuillet et leurs mélanges.

23. Procédé de fabrication d'une dispersion de nanotubes de carbone (7) selon l'une quelconque des revendications 16 à 22, **caractérisé en ce que** les nanotubes (1) sont des nanotubes mono-feuillets.

24. Procédé de fabrication d'une dispersion de nanotubes de carbone (7) selon l'une quelconque des revendications 16 à 23, **caractérisé en ce que** ledit au moins un pigment (3) est choisi dans le groupe constitué par les pigments inorganiques traités afin d'être compatibles avec un polymère ou un solvant organique, les pigments azo, les pigments monoazo jaune et orange, les pigments diazo, les pigments napthol, les pigments napthol AS (napthol rouge) les laques de pigment azo, les pigments benzimidazolone, les pigments de condensation diazo, les pigments complexes de métal, les pigments isoindolinone et isoindoline, les pigments polycycliques, les pigments phthalocyanine, une phthalocyanine de cuivre sulfonéee contenant, en moyenne, 0,5 à 3 groupes d'acide sulfonique, une pthalocyanine de cuivre chlorée broyée, une phthalocyanine d'aluminium, une phthalocyanine bromée, une pthalocyanine d'hydroxyde d'aluminium, une pthalocyanine sans métal, les pigments quinophthalone, les pigments indanthrone, les pigments diarylide jaune, les pigments diazopyrozolione, les pigments azo-métal, les pigments triarylcarbonium, les pigments rhodamine laque, les pigments pérylène, les pigments quinacridone et les pigments dicétopyrrolopyrrole et les mélanges de deux ou plus de ceux-ci.

25. Procédé de fabrication d'une dispersion de nanotubes de carbone (7) selon l'une quelconque des revendications 16 à 24, **caractérisé en ce que** ledit au moins un pigment (3) est la phtalocyanine.

26. Procédé de fabrication d'une dispersion de nanotubes de carbone (7) selon l'une quelconque des revendications 16 à 25, **caractérisé en ce que** ledit polymère (5) est choisi dans le groupe constitué par les polymères d'un ou plusieurs acides organiques ou acides hydroxyliques organiques et leurs dérivés, les polymères d'amines, d'alcools ou de thiols organiques, les copolymères ou copolymères blocs d'un ou plusieurs acides organiques et d'une ou plusieurs polyamines, polyalcools ou polythiols organiques, les copolymères du styrène avec l'éthylène, les copolymères du styrène avec le propylène, les copolymères du styrène avec le butadiène, les copolymères du styrène avec les acrylates, les copolymères du styrène avec les méthacrylates et les combinaisons de deux ou plus de ceux-ci.

27. Procédé de fabrication d'une dispersion de nanotubes de carbone (7) selon l'une quelconque des revendications 16 à 26, **caractérisé en ce que** ledit polymère (5) est un copolymère bloc d'acide hydroxyoctadécanoïque et d'aziridine.

28. Procédé de fabrication d'une dispersion de nanotubes de carbone (7) selon l'une quelconque des revendications 16 à 27, **caractérisé en ce que** le rapport en poids nanotubes (1) / pigment (3) / polymère (5) est compris entre 1/1/1 et 1/5/1.

29. Procédé de fabrication d'une dispersion de nanotubes de carbone selon l'une quelconque des revendications 16 à 28, **caractérisé en ce que** le rapport en poids nanotubes (1) / pigment (3) / polymère (5) est de 1/2/1

30. Procédé de fabrication d'une dispersion de nanotubes de carbone (7) selon l'une quelconque des revendications 16 à 29, **caractérisé en ce que en ce que** le solvant organique (6) est choisi dans le groupe constitué par les hydrocarbures aliphatiques, l'heptane, l'octane, le décane, les hydrocarbures aromatiques, le benzène, le toluène, l'éthylebenzène, le xylène, les hydrocarbures aromatiques et aliphatiques halogénés, le monochlorobenzène, le dichlorobenzène, le dichloroéthylène, le trichloroéthylène, le perchloroéthylène, le tétrachlorocarbone, les acétates, l'acétate de méthyle, l'acétate d'éthyle, l'acétate d'isopropyle, l'acétate de butyle, les cétones, la diisobutylecétone, la diisopropylcétone, la méthylpropylcétone et les mélanges d'un ou plusieurs de ceux-ci.

31. Procédé de fabrication d'une dispersion de nanotubes de carbone (7) selon l'une quelconque des revendications 16 à 30, **caractérisé en ce que** le solvant organique (6) est le xylène.

32. Procédé de fabrication d'une dispersion de nanotubes de carbone (7) selon l'une quelconque des revendications 16 à 31, **caractérisé en ce que** :
- le pourcentage en poids de nanotubes (1) est compris entre 0,01 et 5 % inclus par rapport au poids total de la dispersion,
- le pourcentage en poids de la substance (3) est compris entre 0,01 et 50 % inclus par rapport au poids total de la dispersion, et
- le pourcentage en poids du polymère (5) est compris entre 0,01 et 5 % inclus par rapport au poids total de la dispersion.

33. Procédé de fabrication d'une dispersion de nanotubes de carbone (7), **caractérisé en ce qu'**il consiste à placer les nanotubes (7) selon l'une quelconque des revendications 1 à 10 dans un solvant organique (6) dans lequel le polymère (5) est soluble et à mélanger sous agitation le solvant (6) et les nanotubes (7).

34. Procédé de fabrication d'une dispersion de nanotubes de carbone selon la revendication 33, **caractérisé en ce que** le solvant organique (6) est choisi dans le groupe constitué par les hydrocarbures aliphatiques, l'heptane, l'octane, le décane, les hydrocarbures aromatiques, le benzène, le toluène, l'éthylebenzène, le xylène, les hydrocarbures aromatiques et aliphatiques halogénés, le monochlorobenzène, le dichlorobenzène, le dichloroéthylène, le trichloroéthylène, le perchloroéthylène, le tétrachlorocarbone, les acétates, l'acétate de méthyle, l'acétate d'éthyle, l'acétate d'isopropyle, l'acétate de butyle, les cétones, la diisobutylcétone, la diisopropylcétone, la méthylpropylcétone et les mélanges de deux ou plus de ceux-ci.

35. Procédé de fabrication d'une dispersion de nanotubes de carbone (7) selon la revendication 33 ou 34, **caractérisé en ce que** le solvant organique (6) est le xylène.

36. Procédé de fabrication d'une dispersion de nanotubes de carbone (7) selon l'une quelconque des revendications 33 à 35, **caractérisé en ce que** l'étape de mélange sous agitation du solvant (6) et des nanotubes (7) est effectuée par sonication à la corne.

37. Procédé de fabrication de nanotubes de carbone (7), **caractérisé en ce qu'**il comprend les étapes du procédé de fabrication d'une dispersion selon l'une quelconque des revendications 16 à 19 et 21 à 32 suivies d'une étape d) d'évaporation totale du solvant (6).

38. Matériau composite du type comprenant une matrice polymérique insoluble dans l'eau et des nanotubes de carbone, **caractérisé en ce que** les nanotubes de carbone sont des nanotubes de carbone (7) selon l'une quelconque des revendications 1 à 10.

39. Utilisation des nanotubes de carbone (7) selon l'une quelconque des revendications 1 à 10, ou obtenus par le procédé selon la revendication 37 pour la fabrication d'articles en matériau composite.

40. Utilisation de la dispersion selon l'une quelconque des revendications 11 à 14 ou obtenue par le procédé selon l'une quelconque des revendications 16 à 36 pour la fabrication d'articles en matériau composite.

41. Utilisation selon la revendication 39 ou 40, **caractérisée en ce que** l'article est un film ou une couche mince.

42. Utilisation de la composition selon la revendication 15 pour la fabrication de films ou de couches minces.

43. Procédé de fabrication d'un article en matériau composite du type comprenant une matrice polymérique insoluble dans l'eau et des nanotubes de carbone,
**caractérisé en ce qu'**il comprend :
- les étapes de fabrication d'une dispersion de nanotubes (7) selon l'une quelconque des revendications 16 à 36 et,
- une étape e) de mise en solution du matériau constituant la matrice polymérique insoluble dans l'eau dans un solvant organique (7) dans lequel le matériau constituant la matrice polymérique est soluble,
- une étape f) de mélange de la solution obtenue à l'étape e) avec la dispersion de nanotubes obtenue par le procédé selon l'une quelconque des revendications 16 à 35,
- une étape g) de mise en forme de l'article voulu, et
**en ce que** le solvant (6) utilisé pour fabriquer la dispersion de nanotubes et le solvant (7) utilisé pour dissoudre le matériau constituant la matrice polymérique sont solubles l'un dans l'autre ou miscibles l'une avec l'autre.

44. Procédé selon la revendication 43, **caractérisé en ce que** le solvant (6) et le solvant (7) sont identiques.

45. Procédé selon la revendication 43 ou 44, **caractérisé en ce que** la matrice polymérique est choisie dans le groupe constitué par les polymères thermoplastiques, le polystyrène, le poly(méthacrylate de méthyle), le poly(chlorure de vinyle), le polyéthylène, le poly(téréphtalate d'éthyiène), le poly(oxyde de méthylène), le polyacrylonitrile, ies polyesters, les polyuréthanes, les polyamides, les mélanges et copolymères de deux ou plus de ceux-ci.

46. Procédé selon l'une quelconque des revendications 43 à 45, **caractérisé en ce que** la matrice polymérique est un polyamide.

## Claims

1. Carbon nanotubes (7), **characterized in that** they consist of nanotubes (1) including:
- a layer of at least one pigment (3) directly adsorbed on their external periphery (2), and
- at least one polymer (5) having at least one anchoring point (4) on said layer of at least one pigment (3).

2. The carbon nanotubes (7) according to claim 1, **characterized in that** the nanotubes (1) are selected from the group formed by single-wall nanotubes (SWNT), double-wall nanotubes (DWNT), multi-wall nanotubes (MWNT), nanotubes, the growth of which was carried out in a vapor phase (VGCF), nanofibers or a cylindrical carbon structure and mixtures thereof.

3. The carbon nanotubes (7) according to claim 1, **characterized in that** the nanotubes (1) are selected from the group formed by multi-wall nanotubes, double-wall nanotubes, single-wall nanotubes and mixtures thereof.

4. The carbon nanotubes (7) according to claim 1, **characterized in that** the nanotubes (1) are single-wall nanotubes.

5. The carbon nanotubes (7) according to any of the preceding claims, **characterized in that** said at least one pigment (3) is selected from the group formed by inorganic pigments, treated so as to be compatible with a polymer or an organic solvent, azo pigments, yellow and orange mono-azo pigments, diazo pigments, naphthol pigments, naphthol AS pigments (red naphthol), azo pigment lacquers, benzimidazolone pigments, diazo condensation pigments, metal complex pigments, isoindolinone and isoindoline pigments, polycyclic pigments, phthalocyanine pigments, sulfonated copper phthalocyanine containing on average, 0.5 to 3 sulfonic acid groups, chlorinated copper phthalocyanine, aluminium phthalocyanine, brominated phthalocyanine, aluminium hydroxide phthalocyanine, metal-free phthalocyanine, quinophthalone pigments, indanthrone pigments, yellow diarylide pigments, diazopyrozolione pigments, azo-metal pigments, triarylcarbonium pigments, rhodamine lacquer pigments, perylene pigments, quinacridone pigments and diketopyrrolopyrrole pigments and mixtures of two or more of the latter.

6. The carbon nanotubes (7) according to any of the preceding claims, **characterized in that** said at least one pigment (3) is phthalocyanine.

7. The carbon nanotubes (7) according to any of the preceding claims, **characterized in that** said polymer (5) is selected from the group formed by the polymers of one or several organic acids or organic hydroxylic acids and their derivatives, polymers of organic amines, alcohols or thiols, copolymers or block copolymers of one or several organic acids and of one or several organic polyamines, polyalcohols or polythiols, copolymers of styrene with ethylene, copolymers of styrene with propylene, copolymers of styrene with butadiene, copolymers of styrene with acrylates, copolymers of styrene with methacrylates and combinations of two or more of the latter.

8. The carbon nanotubes (7) according to any of the preceding claims, **characterized in that** said polymer (5) is a block copolymer of hydroxyoctadecanoic acid and aziridine.

9. The carbon nanotubes (7) according to any of the preceding claims, **characterized in that** the nanotubes (1)/pigment (3)/polymer (5) weight ratio is comprised between 1/1/1 and 1/5/1.

10. The carbon nanotubes (7) according to any of the preceding claims, **characterized in that** the nanotubes (1)/pigment (3)/polymer (5) weight ratio is 1/2/1.

11. A dispersion of carbon nanotubes (7), **characterized in that** it comprises nanotubes (7) according to any of the previous claims, uniformly distributed and in a stable way in an organic solvent (6), in which said at least one polymer (5) is soluble.

12. The dispersion according to claim 11, **characterized in that** the organic solvent (6) is selected from the group formed by aliphatic hydrocarbons, heptane, octane, decane, aromatic hydrocarbons, benzene, toluene, ethylbenzene, xylene, halogenated aromatic and aliphatic hydrocarbons, monochlorobenzene, dichlorobenzene, dichloroethylene, trichloroethylene, perchloroethylene, tetrachlorocarbon, acetates, methyl acetate, ethyl acetate, isopropyl acetate, butyl acetate, ketones, diisobutylketone, diisopropylketone, methylpropylketone, and mixtures of two or more of the latter.

13. The dispersion according to claim 11 or 12, **characterized in that** the organic solvent (6) is xylene.

14. The dispersion according to any of claims 11 to 13, **characterized in that**:
- the weight percentage of nanotubes (1) is comprised between 0.01 and 5% inclusive based on the total weight of the dispersion,
- the weight percentage of the pigment (3) is comprised between 0.01 and 50% inclusive based on the total weight of the dispersion, and
- the weight percentage of the polymer (5) is comprised between 0.01 and 5% inclusive based on the total weight of the dispersion.

15. A composition, **characterized in that** it comprises the dispersion according to any of claims 11 to 14, and a propellant.

16. A method for making a dispersion of carbon nanotubes (7), **characterized in that** it comprises the following steps:
a) adding the nanotubes (1), at least one polymer (5), and at least one pigment (3), into an organic solvent (6) in which the polymer (5) is soluble,
b) mixing the composition obtained in step a).

17. The method for making a dispersion of carbon nanotubes (7) according to claim 16, **characterized in that** step a) comprises the following steps:
a₁) mixing the nanotubes (1) and said at least one pigment (3), a₂) adding an organic solvent (6) in which the polymer (5) is soluble, to the mixture obtained in step a₁), and
a₃) adding said at least one polymer (5), to the mixture obtained in step a₂).

18. The method for making a dispersion of carbon nanotubes (7) according to claim 17, **characterized in that** the mixing of step a₁) is carried out by milling.

19. The method for making a dispersion of carbon nanotubes (7) according to any of claims 16 to 18, **characterized in that** the mixing of step b) is carried out by horn sonication.

20. The method for making a dispersion of carbon nanotubes (7) according to any of claims 16 to 19, **characterized in that** it further comprises, after step b), a step c) for evaporating part of the solvent (6).

21. The method for making a dispersion of carbon nanotubes (7) according to any of claims 16 to 20, **characterized in that** the nanotubes (1, 7) are selected from the group formed by single-wall nanotubes (SWNT), double-wall nanotubes (DWNT), multi-wall nanotubes (MWNT), nanotubes, the growth of which was carried out in a vapor phase (VGCF), nanofibers or a cylindrical carbon structure and mixtures thereof.

22. The method for making a dispersion of carbon nanotubes (7) according to any of claims 16 to 21, **characterized in that** the nanotubes (1) are selected from the group formed by multi-wall nanotubes (MWNT), double-wall nanotubes, single-wall nanotubes and mixtures thereof.

23. The method for making a dispersion of carbon nanotubes (7) according to any of claims 16 to 22, **characterized in that** the nanotubes (1) are single-wall nanotubes.

24. The method for making a dispersion of carbon nanotubes (7) according to any of claims 16 to 23, **characterized in that** said at least one pigment (3) is selected from the group formed by inorganic pigments, treated so as to be compatible with a polymer or an organic solvent, azo pigments, yellow and orange monoazo pigments, diazo pigments, naphthol pigments, naphthol AS pigments (red naphthol), azo pigment lacquers, benzimidazolone pigments, diazo condensation pigments, metal complex pigments, isoindolinone and isoindoline pigments, polycyclic pigments, phthalocyanine pigments, sulfonated copper phthalocyanine containing, on average, 0.5 to 3 sulfonic acid groups, milled chlorinated copper phthalocyanine, aluminium phthalocyanine, brominated phthalocyanine, aluminium hydroxide phthalocyanine, metal-free phthalocyanine, quinophthalone pigments, indanthrone pigments, yellow diarylide pigments, diazopyrozolione pigments, azo-metal pigments, triarylcarbonium pigments, rhodamine lacquer pigments, perylene pigments, quinacridone pigments and diketopyrrolopyrrole pigments and mixtures of two or more of the latter.

25. The method for making a dispersion of carbon nanotubes (7) according to any of claims 16 to 24, **characterized in that** said at least one pigment (3) is phthalocyanine.

26. The method for making a dispersion of carbon nanotubes (7) according to any of claims 16 to 25, **characterized in that** said polymer (5) is selected from the group formed by the polymers of one or several organic acids or organic hydroxylic acids and their derivatives, polymers of organic amines, alcohols or thiols, copolymers or block copolymers of one or several organic acids and of one or several organic polyamines, polyalcohols or polythiols, copolymers of styrene with ethylene, copolymers of styrene with propylene, copolymers of styrene with butadiene, copolymers of styrene with acrylates, copolymers of styrene with methacrylates and combinations of two or more of the latter.

27. The method for making a dispersion of carbon nanotubes (7) according to any of claims 16 to 26, **characterized in that** said polymer (5) is a block copolymer of hydroxyoctadecanoic acid and of aziridine.

28. The method for making a dispersion of carbon nanotubes (7) according to any of claims 16 to 27, **characterized in that** the nanotubes (1)/pigment (3)/polymer (5) weight ratio is comprised between 1/1/1 and 1/5/1.

29. The method for making a dispersion of carbon nanotubes (7) according to any of claims 16 to 28, **characterized in that** the nanotubes (1)/pigment (3)/polymer (5) weight ratio is 1/2/1.

30. The method for making a dispersion of carbon nanotubes (7) according to any of claims 16 to 29, **characterized in that** the organic solvent (6) is selected from the group formed by aliphatic hydrocarbons, heptane, octane, decane, aromatic hydrocarbons, benzene, toluene, ethylbenzene, xylene, halogenated aromatic and aliphatic hydrocarbons, monochlorobenzene, dichlorobenzene, dichloroethylene, trichloroethylene, perchloroethylene, tetrachlorocarbon, acetates, methyl acetate, ethyl acetate, isopropyl acetate, butyl acetate, ketones, diisobutylketone, diisopropylketone, methylpropylketone, and mixtures of one or more of the latter.

31. The method for making a dispersion of carbon nanotubes (7) according to any of claims 16 to 30, **characterized in that** the organic solvent (6) is xylene.

32. The method for making a dispersion of carbon nanotubes (7) according to any of claim 16 to 31, **characterized in that**:
- the weight percentage of nanotubes (1) is comprised between 0.01 and 5% inclusive based on the total weight of the dispersion,
- the weight percentage of the substance (3) is comprised between 0.01 and 50% inclusive based on the total weight of the dispersion, and
- the weight percentage of the polymer (5) is comprised between 0.01 and 5% inclusive based on the total weight of the dispersion.

33. A method for making a dispersion of carbon nanotubes (7) **characterized in that** it consists of placing the nanotubes (7) according to any of claims 1 to 10 in an organic solvent (6) in which the polymer (5) is soluble and of mixing with stirring the solvent (6) and the nanotubes (7).

34. The method for making a dispersion of carbon nanotubes according to claim 33, **characterized in that** the organic solvent (6) is selected from the group formed by aliphatic hydrocarbons, heptane, octane, decane, aromatic hydrocarbons, benzene, toluene, ethylbenzene, xylene, halogenated aromatic and aliphatic hydrocarbons, monochlorobenzene, dichlorobenzene, dichloroethylene, trichloroethylene, perchloroethylene, tetrachlorocarbon, acetates, methyl acetate, ethyl acetate, isopropyl acetate, butyl acetate, ketones, diisobutylketone, diisopropylketone, methylpropylketone, and mixtures of two or more of the latter.

35. The method for making a dispersion of carbon nanotubes (7) according to claim 33 or 34, **characterized in that** the organic solvent (6) is xylene.

36. The method for making a dispersion of carbon nanotubes (7) according to any of claims 33 to 35, **characterized in that** the step for mixing with stirring the solvent (6) and the nanotubes (7) is carried out by horn sonication.

37. A method for making carbon nanotubes (7), **characterized in that** it comprises the steps of the method for making a dispersion according to any of claims 16 to 19 and 21 to 32 followed by a step d) for total evaporation of the solvent (6).

38. A composite material of the type comprising a polymeric matrix insoluble in water and carbon nanotubes, **characterized in that** the carbon nanotubes are the carbon nanotubes (7) according to any of claims 1 to 10.

39. The use of carbon nanotubes (7) according to any of claims 1 to 10, or obtained by the method according to claim 37 for making articles in composite material.

40. The use of the dispersion according to any of claims 11 to 14 or obtained by the method according to any of claims 16 to 36 for making articles in composite material.

41. The use according to claim 39 or 40, **characterized in that** the article is a film or thin layer.

42. The use of the composition according to claim 15 for making films or thin layers.

43. A method for making an article in a composite material of the type comprising a polymeric matrix insoluble in water and carbon nanotubes, **characterized in that** it comprises:
- the steps for making a dispersion of nanotubes (7) according to any of claims 16 to 36 and,
- a step e) for putting into solution the material making up the water-insoluble polymeric matrix in an organic solvent (7) in which the material making up the polymeric matrix is soluble,
- a step f) for mixing the solution obtained in step e) with the dispersion of nanotubes obtained by the method according to any of claims 16 to 35,
- a step g) for shaping the intended article, and
**in that** the solvent (6) used for making the dispersion of nanotubes and the solvent (7) used for dissolving the material making up the polymeric matrix, are soluble in each other and miscible with each other.

44. The method according to claim 43, **characterized in that** the solvent (6) and the solvent (7) are identical.

45. The method according to claim 43 or 44, **characterized in that** the polymeric matrix is selected from the group formed by thermoplastic polymers, polystyrene, poly(methyl methacrylate), poly(vinyl chloride), polyethylene, poly(ethylene terephthalate), poly(methylene oxide), polyacronitrile, polyesters, polyurethanes, polyamides, mixtures and copolymers of two or more of the latter.

46. The method according to any of claims 43 to 45, **characterized in that** the polymeric matrix is a polyamide.

## Patentansprüche

1. Kohlenstoff-Nanoröhren (7), **dadurch gekennzeichnet, daß** sie von Nanoröhren (1) gebildet sind, die umfassen:
- eine Schicht aus wenigstens einem direkt an ihrem Außenumfang (2) adsorbierten Pigment (3) und
- wenigstens ein Polymer (5), das wenigstens eine Verankerungsstelle (4) an der Schicht aus wenigstens einem Pigment (3) hat.

2. Kohlenstoff-Nanoröhren (7) nach Anspruch 1, **dadurch gekennzeichnet, daß** die Nanoröhren (1) aus der Gruppe bestehend aus den einwandigen Nanoröhren (SWNT), den doppelwandigen Nanoröhren (DWNT), den mehrwandigen Nanoröhren (MWNT), den aus der Gasphase gewachsenen Nanoröhren (VGCF), den Nanofasern oder einer zylindrischen Kohlenstoffstruktur sowie ihren Mischungen ausgewählt sind.

3. Kohlenstoff-Nanoröhren (7) nach Anspruch 1, **dadurch gekennzeichnet, daß** die Nanoröhren (1) aus der Gruppe bestehend aus den mehrwandigen Nanoröhren, den doppelwandigen Nanoröhren, den einwandigen Nanoröhren sowie ihren Mischungen ausgewählt sind.

4. Kohlenstoff-Nanoröhren (7) nach Anspruch 1, **dadurch gekennzeichnet, daß** die Nanoröhren (1) einwandige Nanoröhren sind.

5. Kohlenstoff-Nanoröhren (7) nach einem der vorhergehenden Ansprüche, **dadurch gekennzeichnet, daß** das wenigstens eine Pigment (3) ausgewählt ist aus der Gruppe bestehend aus den anorganischen Pigmenten, die behandelt sind, um mit einem Polymer oder einem organischen Lösungsmittel kompatibel zu sein, den Azopigmenten, den gelben und orangefarbenen Monoazopigmenten, den Diazopigmenten, den Naphthol-Pigmenten, den Naphthol AS-Pigmenten (Naphtholrot), den Azopigmentlacken, den Benzimidazolonpigmenten, den Diazo-Kondensationspigmenten, den komplexen Metallpigmenten, den Isoindolinon- und Isoindolinpigmenten, den polycyclischen Pigmenten, den Phthalocyaninpigmenten, einem sulfonierten Kupfer-Phthalocyanin mit durchschnittlich 0,5 bis 3 Sulfonsäuregruppen, einem chlorierten Kupfer-Phthalocyanin, einem Aluminium-Phthalocyanin, einem bromierten Phthalocyanin, einem Aluminiumhydroxid-Phthalocyanin, einem metallfreien Phthalocyanin, den Chinophthalon-Pigmenten, den Indanthron-Pigmenten, den Diarylid-Gelb-Pigmenten, den Diazopyrozolion-Pigmenten, den Azo-Metall-Pigmenten, den Triarylcarbonium-Pigmenten, den Rhodamin-Lack-Pigmenten, den Perylen-Pigmenten, den Chinacridon-Pigmenten und den Diketopyrrolopyrrol-Pigmenten sowie den Mischungen aus zwei oder mehr davon.

6. Kohlenstoff-Nanoröhren (7) nach einem der vorhergehenden Ansprüche, **dadurch gekennzeichnet, daß** das wenigstens eine Pigment (3) Phthalocyanin ist.

7. Kohlenstoff-Nanoröhren (7) nach einem der vorhergehenden Ansprüche, **dadurch gekennzeichnet, daß** das Polymer (5) ausgewählt ist aus der Gruppe bestehend aus den Polymeren aus einer oder mehreren organischen Säuren oder organischen Hydroxysäuren und ihren Derivaten, den Polymeren aus organischen Aminen, Alkoholen oder Thiolen, den Copolymeren oder Blockcopolymeren aus einer oder mehreren organischen Säuren und aus einem oder mehreren organischen Polyaminen, Polyalkoholen oder Polythiolen, den Styrol-Ethylen-Copolymeren, den Styrol-Propylen-Copolymeren, den Styrol-Butadien-Copolymeren, den Styrol-Acrylat-Copolymeren, den Styrol-Methacrylat-Copolymeren sowie den Kombinationen aus zwei oder mehr davon.

8. Kohlenstoff-Nanoröhren (7) nach einem der vorhergehenden Ansprüche, **dadurch gekennzeichnet, daß** das Polymer (5) ein Blockcopolymer aus Hydroxyoctadecansäure und Aziridin ist.

9. Kohlenstoff-Nanoröhren (7) nach einem der vorhergehenden Ansprüche, **dadurch gekennzeichnet, daß** das Gewichtsverhältnis Nanoröhren (1) / Pigment (3) / Polymer (5) im Bereich zwischen 1 / 1 / 1 und 1 / 5 / 1 liegt.

10. Kohlenstoff-Nanoröhren (7) nach einem der vorhergehenden Ansprüche, **dadurch gekennzeichnet, daß** das Gewichtsverhältnis Nanoröhren (1) / Pigment (3) / Polymer (5) 1 / 2 / 1 beträgt.

11. Dispersion von Kahlenstaff-tilanaröhren (7), **dadurch gekennzeichnet, daß** sie die Nanoröhren (7) nach einem der vorhergehenden Ansprüche umfaßt, die in einem organischen Lösungsmittel (6), in dem das wenigstens eine Polymer (5) löslich ist, gleichmäßig und stabil verteilt sind.

12. Dispersion nach Anspruch 11, **dadurch gekennzeichnet, daß** das organische Lösungsmittel (6) ausgewählt ist aus der Gruppe bestehend aus den aliphatischen Kohlenwasserstoffen, Heptan, Octan, Decan, den aromatischen Kohlenwasserstoffen, Benzol, Toluol, Ethylbenzol, Xylol, den halogenierten aromatischen und aliphatischen Kohlenwasserstoffen, Monochlorbenzol, Dichlorbenzol, Dichlorethylen, Trichlorethylen, Perchlorethylen, Tetrachlorkohlenstoff, den Acetaten, Methylacetat, Ethylacetat, Isopropylacetat, Butylacetat, den Ketonen, Diisobutylketon, Diisopropylketon, Methylpropylketon und den Mischungen aus zwei oder mehr davon.

13. Dispersion nach Anspruch 11 oder 12, **dadurch gekennzeichnet, daß** das organische Lösungsmittel (6) Xylol ist.

14. Dispersion nach einem der Ansprüche 11 bis 13, **dadurch gekennzeichnet, daß**:
- der Gewichtsprozentsatz der Nanoröhren (1), bezogen auf das Gesamtgewicht der Dispersion, zwischen 0,01 und einschließlich 5 % beträgt,
- der Gewichtsprozentsatz des Pigments (3), bezogen auf das Gesamtgewicht der Dispersion, zwischen 0,01 und einschließlich 50 % beträgt und
- der Gewichtsprozentsatz des Polymers (5), bezogen auf das Gesamtgewicht der Dispersion, zwischen 0,01 und einschließlich 5 % beträgt.

15. Zusammensetzung, **dadurch gekennzeichnet, daß** sie die Dispersion nach einem der Ansprüche 11 bis 14 sowie ein Treibmittel umfaßt.

16. Verfahren zur Herstellung einer Dispersion von Kohlenstoff-Nanoröhren (7), **dadurch gekennzeichnet, daß** es die folgenden Schritte umfaßt:
a) Zugabe der Nanoröhren (1), wenigstens eines Polymers (5) und wenigstens eines Pigments (3) in ein organisches Lösungsmittel (6), in dem das Polymer (5) löslich ist,
b) Mischen der bei Schritt a) erhaltenen Zusammensetzung.

17. Verfahren zur Herstellung einer Dispersion von Kohlenstoff-Nanoröhren (7) nach Anspruch 16, **dadurch gekennzeichnet, daß** Schritt a) die folgenden Schritte umfaßt:
a₁) Mischen der Nanoröhren (1) und des wenigstens einen Pigments (3), a₂) Zugabe eines organischen Lösungsmittels (6), in dem das Polymer (5) löslich ist, zu der bei Schritt a₁) erhaltenen Mischung und
a₃) Zugabe des wenigstens einen Polymers (5) zu der bei Schritt a₂) erhaltenen Mischung.

18. Verfahren zur Herstellung einer Dispersion von Kohlenstoff-Nanoröhren (7) nach Anspruch 17, **dadurch gekennzeichnet, daß** das Mischen des Schrittes a₁) durch Mahlen erfolgt.

19. Verfahren zur Herstellung einer Dispersion von Kohlenstoff-Nanoröhren (7) nach einem der Ansprüche 16 bis 18, **dadurch gekennzeichnet, daß** das Mischen des Schrittes b) durch Beschallen mittels Horn erfolgt.

20. Verfahren zur Herstellung einer Dispersion von Kohlenstoff-Nanoröhren (7) nach einem der Ansprüche 16 bis 19, **dadurch gekennzeichnet, daß** es weiterhin, nach Schritt b), einen Schritt c) zum Verdampfen eines Teils des Lösungsmittels (6) umfaßt.

21. Verfahren zur Herstellung einer Dispersion von Kohlenstoff-Nanoröhren (7) nach einem der Ansprüche 16 bis 20, **dadurch gekennzeichnet, daß** die Nanoröhren (1, 7) aus der Gruppe bestehend aus den einwandigen Nanoröhren (SWNT), den doppelwandigen Nanoröhren (DWNT), den mehrwandigen Nanoröhren (MWNT), den aus der Gasphase gewachsenen Nanoröhren (VGCF), den Nanofasern oder einer zylindrischen Kohlenstoffstruktur sowie ihren Mischungen ausgewählt sind.

22. Verfahren zur Herstellung einer Dispersion von Kohlenstoff-Nanoröhren (7) nach einem der Ansprüche 16 bis 21, **dadurch gekennzeichnet, daß** die Nanoröhren (1) aus der Gruppe bestehend aus den mehrwandigen Nanoröhren (MWNT), den doppelwandigen Nanoröhren, den einwandigen Nanoröhren sowie ihren Mischungen ausgewählt sind.

23. Verfahren zur Herstellung einer Dispersion von Kohlenstoff-Nanoröhren (7) nach einem der Ansprüche 16 bis 22, **dadurch gekennzeichnet, daß** die Nanoröhren (1) einwandige Nanoröhren sind.

24. Verfahren zur Herstellung einer Dispersion von Kohlenstoff-Nanoröhren (7) nach einem der Ansprüche 16 bis 23, **dadurch gekennzeichnet, daß** das wenigstens eine Pigment (3) ausgewählt ist aus der Gruppe bestehend aus den anorganischen Pigmenten, die behandelt sind, um mit einem Polymer oder einem organischen Lösungsmittel kompatibel zu sein, den Azopigmenten, den gelben und orangefarbenen Monoazopigmenten, den Diazopigmenten, den Naphthol-Pigmenten, den Naphthol AS-Pigmenten (Naphtholrot), den Azopigmentlacken, den Benzimidazolonpigmenten, den Diazo-Kondensationspigmenten, den komplexen Metallpigmenten, den Isoindolinon- und Isoindolinpigmenten, den polycyclischen Pigmenten, den Phthalocyaninpigmenten, einem sulfonierten Kupfer-Phthalocyanin mit durchschnittlich 0,5 bis 3 Sulfonsäuregruppen, einem gemahlenen chlorierten Kupfer-Phthalocyanin, einem Aluminium-Phthalocyanin, einem bromierten Phthalocyanin, einem Aluminiumhydroxid-Phthalocyanin, einem metallfreien Phthalocyanin, den Chinophthalon-Pigmenten, den Indanthron-Pigmenten, den Diarylid-Gelb-Pigmenten, den Diazopyrozolion-Pigmenten, den Azo-Metall-Pigmenten, den Triarylcarbonium-Pigmenten, den Rhodamin-Lack-Pigmenten, den Perylen-Pigmenten, den Chinacridon-Pigmenten und den Diketopyrrolopyrrol-Pigmenten sowie den Mischungen aus zwei oder mehr davon.

25. Verfahren zur Herstellung einer Dispersion von Kohlenstoff-Nanoröhren (7) nach einem der Ansprüche 16 bis 24, **dadurch gekennzeichnet, daß** das wenigstens eine Pigment (3) Phthalocyanin ist.

26. Verfahren zur Herstellung einer Dispersion von Kohlenstoff-Nanoröhren (7) nach einem der Ansprüche 16 bis 25, **dadurch gekennzeichnet, daß** das Polymer (5) ausgewählt ist aus der Gruppe bestehend aus den Polymeren aus einer oder mehreren organischen Säuren oder organischen Hydroxysäuren und ihren Derivaten, den Polymeren aus organischen Aminen, Alkoholen oder Thiolen, den Copolymeren oder Blockcopolymeren aus einer oder mehreren organischen Säuren und aus einem oder mehreren organischen Polyaminen, Polyalkoholen oder Polythiolen, den Styrol-Ethylen-Copolymeren, den Styrol-Propylen-Copolymeren, den Styrol-Butadien-Copolymeren, den Styrol-Acrylat-Copolymeren, den Styrol-Methacrylat-Copolymeren sowie den Kombinationen aus zwei oder mehr davon.

27. Verfahren zur Herstellung einer Dispersion von Kohlenstoff-Nanoröhren (7) nach einem der Ansprüche 16 bis 26, **dadurch gekennzeichnet, daß** das Polymer (5) ein Blockcopolymer aus Hydroxyoctadecansäure und Aziridin ist.

28. Verfahren zur Herstellung einer Dispersion von Kohlenstoff-Nanoröhren (7) nach einem der Ansprüche 16 bis 27, **dadurch gekennzeichnet, daß** das Gewichtsverhältnis Nanoröhren (1) / Pigment (3) / Polymer (5) im Bereich zwischen 1 /1 / 1 und 1 / 5 / 1 liegt.

29. Verfahren zur Herstellung einer Dispersion von Kohlenstoff-Nanoröhren nach einem der Ansprüche 16 bis 28, **dadurch gekennzeichnet, daß** das Gewichtsverhältnis Nanoröhren (1) / Pigment (3) / Polymer (5) 1 / 2 / 1 beträgt.

30. Verfahren zur Herstellung einer Dispersion von Kohlenstoff-Nanoröhren (7) nach einem der Ansprüche 16 bis 29, **dadurch gekennzeichnet, daß** das organische Lösungsmittel (6) ausgewählt ist aus der Gruppe bestehend aus den aliphatischen Kohlenwasserstoffen, Heptan, Octan, Decan, den aromatischen Kohlenwasserstoffen, Benzol, Toluol, Ethylbenzol, Xylol, den halogenierten aromatischen und aliphatischen Kohlenwasserstoffen, Monochlorbenzol, Dichlorbenzol, Dichlorethylen, Trichlorethylen, Perchlorethylen, Tetrachlorkohlenstoff, den Acetaten, Methylacetat, Ethylacetat, Isopropylacetat, Butylacetat, den Ketonen, Diisobutylketon, Diisopropylketon, Methylpropylketon und den Mischungen aus einem oder mehreren davon.

31. Verfahren zur Herstellung einer Dispersion von Kohlenstoff-Nanoröhren (7) nach einem der Ansprüche 16 bis 30, **dadurch gekennzeichnet, daß** das organische Lösungsmittel (6) Xylol ist.

32. Verfahren zur Herstellung einer Dispersion von Kohlenstoff-Nanoröhren (7) nach einem der Ansprüche 16 bis 31, **dadurch gekennzeichnet, daß**:
- der Gewichtsprozentsatz der Nanoröhren (1), bezogen auf das Gesamtgewicht der Dispersion, zwischen 0,01 und einschließlich 5 % beträgt,
- der Gewichtsprozentsatz der Substanz (3), bezogen auf das Gesamtgewicht der Dispersion, zwischen 0,01 und einschließlich 50 % beträgt und
- der Gewichtsprozentsatz des Polymers (5), bezogen auf das Gesamtgewicht der Dispersion, zwischen 0,01 und einschließlich 5 % beträgt.

33. Verfahren zur Herstellung einer Dispersion von Kohlenstoff-Nanoröhren (7), **dadurch gekennzeichnet, daß** es darin besteht, die Nanoröhren (7) nach einem der Ansprüche 1 bis 10 in ein organisches Lösungsmittel (6) zu geben, in dem das Polymer (5) löslich ist, und das Lösungsmittel (6) und die Nanoröhren (7) unter Rühren zu mischen.

34. Verfahren zur Herstellung einer Dispersion von Kohlenstoff-Nanoröhren nach Anspruch 33, **dadurch gekennzeichnet, daß** das organische Lösungsmittel (6) ausgewählt ist aus der Gruppe bestehend aus den aliphatischen Kohlenwasserstoffen, Heptan, Octan, Decan, den aromatischen Kohlenwasserstoffen, Benzol, Toluol, Ethylbenzol, Xylol, den halogenierten aromatischen und aliphatischen Kohlenwasserstoffen, Monochlorbenzol, Dichlorbenzol, Dichlorethylen, Trichlorethylen, Perchlorethylen, Tetrachlorkohlenstoff, den Acetaten, Methylacetat, Ethylacetat, Isopropylacetat, Butylacetat, den Ketonen, Diisobutylketon, Diisopropylketon, Methylpropylketon und den Mischungen aus zwei oder mehr davon.

35. Verfahren zur Herstellung einer Dispersion von Kohlenstoff-Nanoröhren (7) nach Anspruch 33 oder 34, **dadurch gekennzeichnet, daß** das organische Lösungsmittel (6) Xylol ist.

36. Verfahren zur Herstellung einer Dispersion von Kohlenstoff-Nanoröhren (7) nach einem der Ansprüche 33 bis 35, **dadurch gekennzeichnet, daß** der Schritt des Mischens unter Rühren des Lösungsmittels (6) und der Nanoröhren (7) durch Beschallen mittels Horn vollzogen wird.

37. Verfahren zur Herstellung von Kohlenstoff-Nanoröhren (7), **dadurch gekennzeichnet, daß** es die Schritte des Verfahrens zur Herstellung einer Dispersion nach einem der Ansprüche 16 bis 19 und 21 bis 32 umfaßt, an die sich ein Schritt d) zum vollständigen Verdampfen des Lösungsmittels (6) anschließt.

38. Verbundwerkstoff vom Typ umfassend eine wasserunlösliche Polymermatrix und Kohlenstoff-Nanoröhren, **dadurch gekennzeichnet, daß** die Kohlenstoff-Nanoröhren Kohlenstoff-Nanoröhren (7) nach einem der Ansprüche 1 bis 10 sind.

39. Verwendung der Kohlenstoff-Nanoröhren (7) nach einem der Ansprüche 1 bis 10 oder erhalten mittels des Verfahrens nach Anspruch 37, für die Herstellung von Artikeln aus Verbundwerkstoff.

40. Verwendung der Dispersion nach einem der Ansprüche 11 bis 14 oder erhalten mittels des Verfahrens nach einem der Ansprüche 16 bis 36, für die Herstellung von Artikeln aus Verbundwerkstoff.

41. Verwendung nach Anspruch 39 oder 40, **dadurch gekennzeichnet, daß** der Artikel ein Film oder eine dünne Schicht ist.

42. Verwendung der Zusammensetzung nach Anspruch 15, für die Herstellung von Filmen oder dünnen Schichten.

43. Verfahren zur Herstellung eines Artikels aus Verbundwerkstoff vom Typ umfassend eine wasserunlösliche Polymermatrix und Kohlenstoff-Nanoröhren, **dadurch gekennzeichnet, daß** es umfaßt:
- die Schritte zur Herstellung einer Dispersion von Nanoröhren (7) nach einem der Ansprüche 16 bis 36 und
- einen Schritt e) zum Lösen des die wasserunlösliche Polymermatrix bildenden Materials in einem organischen Lösungsmittel (7), in dem das die Polymermatrix bildende Material löslich ist,
- einen Schritt f) zum Mischen der bei Schritt e) erhaltenen Lösung mit der mittels des Verfahrens nach einem der Ansprüche 16 bis 35 erhaltenen Nanoröhren-Dispersion,
- einen Schritt g) zum Formen des gewünschten Artikels und
daß das Lösungsmittel (6), das für die Herstellung der Nanoröhren-Dispersion verwendet wird, und das Lösungsmittel (7), das zum Lösen des die Polymermatrix bildenden Materials verwendet wird, ineinander löslich oder miteinander mischbar sind.

44. Verfahren nach Anspruch 43, **dadurch gekennzeichnet, daß** das Lösungsmittel (6) und das Lösungsmittel (7) identisch sind.

45. Verfahren nach Anspruch 43 oder 44, **dadurch gekennzeichnet, daß** die Polymermatrix ausgewählt ist aus der Gruppe bestehend aus den thermoplastischen Polymeren, Polystyrol, Polymethylmethacrylat, Polyvinylchlorid, Polyethylen, Polyethylenterephthalat, Polymethylenoxid, Polyacrylnitril, den Polyestern, den Polyurethanen, den Polyamiden, den Mischungen und Copolymeren aus zwei oder mehr davon.

46. Verfahren nach einem der Ansprüche 43 bis 45, **dadurch gekennzeichnet, daß** die Polymermatrix ein Polyamid ist.
